# EUROPEAN PATENT SPECIFICATION

(11) **EP 1 664 237 B1**
(45) Date of publication and mention of the grant of the patent: **08.10.2008**
(21) Application number: 04772720.1
(22) Date of filing: 27.08.2004
(51) Int. Cl.: C09K 11/06, C08F 212/32

(54) **PHOSPHORESCENT POLYMER COMPOUND AND ORGANIC LIGHT EMITTING DEVICE USING THE SAME**
PHOSPHORESZIERENDE POLYMERVERBINDUNG UND DARAUF BASIERENDE ORGANISCHE LICHTEMITTIERENDE VORRICHTUNG
COMPOSE POLYMERE PHOSPHORESCENT ET DISPOSITIF ELECTROLUMINESCENT ORGANIQUE UTILISANT LEDIT COMPOSE

(30) Priority: 29.08.2003 JP 2003306711
(43) Date of publication of application: 07.06.2006
(73) Proprietor: Showa Denko K.K., Tokyo 105-8513 (JP)
(72) Inventor: KOYAMA, Tamami, c/o Corporate R & D Center, Chiba-shi, Chiba 267-0056 (JP); IGARASHI, Takeshi, c/o Corporate R & D Center, Chiba-shi, Chiba 267-0056 (JP); KONDOH, Kunio, c/o Corporate R & D Center, Chiba-shi, Chiba 267-0056 (JP); TAGUCHI, Isamu, c/o Corporate R & D Center, Chiba-shi, Chiba 267-0056 (JP); MONDEN, Ryuji, c/o Corporate R & D Center, Chiba-shi, Chiba 267-0056 (JP)
(74) Representative: Strehl, Peter
(86) International application number: PCT/JP2004/012771
(87) International publication number: WO 2005/021678

(56) References cited:
- EP-A- 1 298 736
- WO-A-03/018653
- TAMADA M ET AL: "Thermal stability and EL efficiency of polymer thin film prepared from TPD-acrylate" POLYMER, ELSEVIER SCIENCE PUBLISHERS B.V, GB, vol. 41, no. 15, July 2000 (2000-07), pages 5661-5667, XP004193877 ISSN: 0032-3861
- DOMERCQ B ET AL: "Photo-crosslinkable polymers as hole transport materials for organic light-emitting diodes" PROCEEDINGS OF THE SPIE, SPIE, BELLINGHAM, VA, US, vol. 4642, 2000, pages 88-96, XP002297916 ISSN: 0277-786X
- PATENT ABSTRACTS OF JAPAN vol. 2000, no. 04, 31 August 2000 (2000-08-31) & JP 2000 012882 A (FUJI PHOTO FILM CO LTD), 14 January 2000 (2000-01-14)

## Description

### TECHNICAL FIELD

The present invention relates to a phosphorescent polymer compound and an organic light emitting device (OLED) for flat display panels or backlights used therein.

### BACKGROUND ART

Materials and structures of organic light emitting devices have been improved rapidly since C. W. Tang, et al. of Eastman Kodak Company disclosed a high-luminance device in 1987 (Appl. Phys. Lett., Vol. 51, Page 913, 1987), and the devices have recently been put into practical use in displays of car audio systems and cellular phones, etc. To further widen the application of these organic EL (electroluminescent) devices, materials for increasing the light emitting efficiency or the durability, full-color display systems, etc. are now being actively developed. Particularly in view of applying the devices to middle- or large-sized panels and illuminators, the light emitting efficiency needs to be increased to achieve a higher luminance. However, conventional organic EL devices utilize light emission from an excited singlet state, that is, fluorescence, and because the formation ratio of singlet excitons to triplet excitons is 1/3 in electroexcitation, the upper limit of the internal quantum efficiency in organic light emitting device is 25% (equivalent to the external quantum efficiency of 5% when the light out-coupling efficiency is 20%).

Under the circumstances, M. A. Baldo, et al. disclosed that an iridium complex, etc. capable of emitting phosphorescence in the excited triplet state at the room temperature can achieve the external quantum efficiency of 7.5% (equivalent to the internal quantum efficiency of 37.5% when the light out-coupling efficiency is 20%), which exceeds the conventional external quantum efficiency upper limit of 5%. Further, a higher efficiency of almost 20% was achieved by modifying a host material or structure of the device *(*Appl. Phys. Lett., Vol. 90, Page 5048, 2001), and this has been attracting attention as a method for achieving an extra-high efficiency. Specifically the method uses 4,4'-N,N'-dicarbazole biphenyl (CBP) , etc. as a host material (WO 01/41512).

However, this phosphorescent iridium complex is a low molecular weight compound and is formed into a film by a vacuum deposition method. Though the vacuum deposition method has been widely used for forming films of low molecular weight light emitting materials, the method is disadvantageous in that a vacuum apparatus is required and that the larger the area of the organic film to be formed is, the more difficult it is to form the film with a uniform thickness or a highly dense pattern. Thus, the method is not necessarily suitable for mass production of a large area panel.

In the circumstances, in relation to method suitable for producing organic light emitting device having a larger light-emission area and mass production method therefor, methods of forming light emitting polymer materials into films by spin coating methods, ink-jet methods, printing methods, etc. have been developed. These technologies have been widely used for fluorescent polymer materials and also, application of such a method in phosphorescent polymer materials is being developed. It has been reported that an external quantum efficiency of more than 5% can be obtained by using a phosphorescent polymer material with a side chain containing a phosphorescent moiety and a carrier transporting moiety (Proceedings of The 11th International Workshop on Inorganic and Organic Electroluminescence (EL2002), p.283-286, 2002). In this document, the hole transporting moiety has a vinylcarbazole structure.

However, the above phosphorescent polymer material shows an external quantum efficiency of about 6%, which is only slightly more than the external quantum efficiency limit 5% of the fluorescent devices. Thus, this material cannot achieve the expected high external quantum efficiency of the phosphorescent devices.

WO 03/018653 discloses polymers comprising a phosphorescent unit being a metal complex monomer and a hole transporting unit.

EP-A-1 298 736 discloses a light emitting device having an anode, a cathode, and a layer comprising at least one organic compound, wherein the anode may have been treated by a UV ozone treatment or plasma treatment.

Domercq, B. et al.: "Photo-crosslinkable polymers as hole transport materials for organic light-emitting diodes" PRPOCEEDINGS OF SPIE, Vol. 4642 (2000), pages 88-96 discloses arylamine-based hole transporting polymers.

### DISCLOSURE OF THE INVENTION

Though high-efficient phosphorescent polymer materials suitable for increasing emission area and for mass production have been developed, a phosphorescent material and an organic light emitting device using the same capable of showing a sufficiently high efficiency at a low voltage have not yet obtained. Accordingly, an object of the present invention is to provide a phosphorescent polymer material and an organic light emitting device using the same, which can show a high light emitting efficiency at a low voltage and is suitable for production of large screen OELD display and for the mass production.

As a result of various research with the view that the conventional phosphorescent polymer materials require high driving voltage and show a low power efficiency because of the vinylcarbazole structures of the hole transporting moieties, the inventors have found that the driving voltage can be reduced and the external quantum efficiency can be increased by using a triphenylamine structure for the hole transporting moiety. The present invention has been accomplished by this finding.

Thus, the present invention relates to the following phosphorescent polymer compound and organic light emitting device.
1. A phosphorescent polymer compound comprising a phosphorescent monomer unit and a monomer unit represented by the formula (1): 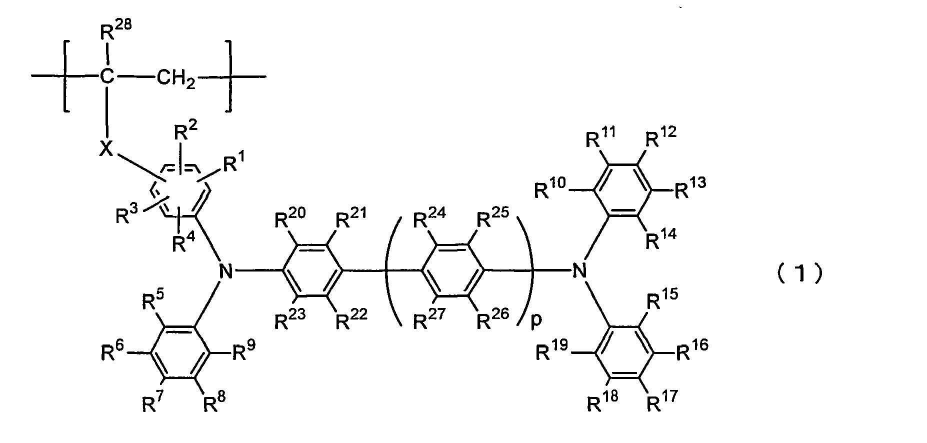 wherein R¹ to R²⁷ independently represent a hydrogen atom, a halogen atom, a cyano group, an amino group, an alkyl group having 1 to 6 carbon atoms, or an alkoxy group having 1 to 6 carbon atoms, groups of R¹ to R¹⁹ connecting to adjacent carbon atoms in the same phenyl group may be bonded together to form a condensed ring; R²⁸ represents a hydrogen atom or an alkyl group having 1 to 6 carbon atoms; X represents a single bond, an oxygen atom (-O-) , a sulfur atom (-S-), -SO-, -SO₂-, -NR- (in which R represents a hydrogen atom, an alkyl group having 1 to 4 carbon atoms, or a phenyl group), -CO-, or a divalent organic group having 1 to 20 carbon atoms, the organic group may be substituted by atom or group selected from the group consisting of an oxygen atom (-O-), a sulfur atom (-S-), -SO-, -SO₂- -NR- (in which R represents a hydrogen atom, an alkyl group having 1 to 4 carbon atoms, or a phenyl group), and -CO-; and p is 0 or 1.
2. The phosphorescent polymer compound according to 1, comprising the phosphorescent monomer unit and a monomer unit represented by the formula (2): 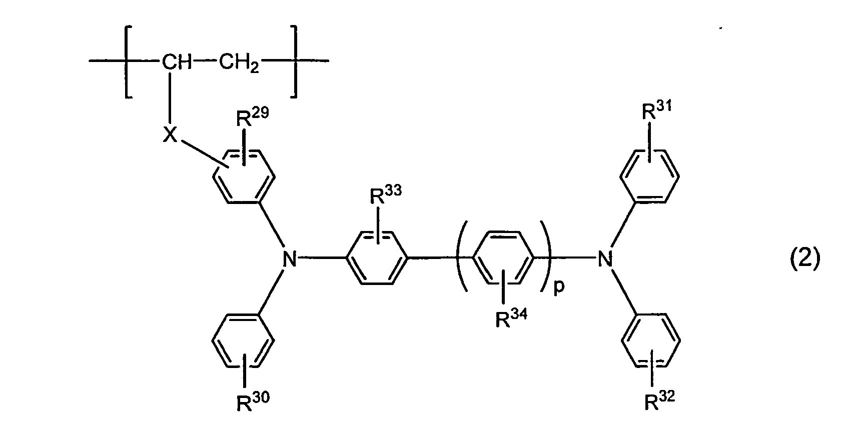 wherein R²⁹ to R³⁴ independently represent a hydrogen atom, an alkyl group having 1 to 6 carbon atoms, or an alkoxy group having 1 to 6 carbon atoms; X represents a single bond, an oxygen atom (-O-), a sulfur atom (-S-), -SO-, -SO₂- -NR- (in which R represents a hydrogen atom, an alkyl group having 1 to 4 carbon atoms, or a phenyl group), -CO-, or a divalent organic group having 1 to 20 carbon atoms, the organic group may be substituted by atom or group selected from the group consisting of an oxygen atom (-O-), a sulfur atom (-S-) , -SO-, -SO₂-, -NR- (in which R represents a hydrogen atom, an alkyl group having 1 to 4 carbon atoms, or a phenyl group), and -CO-; and p is 0 or 1.
3. The phosphorescent polymer compound according to 1 or 2, further comprising an electron transporting monomer unit.
4. The phosphorescent polymer compound according to 3, wherein the electron transporting moiety in the electron transporting monomer unit is selected from the group consisting of an oxadiazole derivative, a triazole derivative, a triazine derivative, a benzoxazole derivative, an imidazole derivative and a quinolinol derivative metal complex.
5. The phosphorescent polymer compound according to 1 or 2, wherein the phosphorescent monomer unit comprises a polymerizable group and a phosphorescent moiety, and the phosphorescent moiety is contained in a side chain of the phosphorescent polymer.
6. The phosphorescent polymer compound according to 1 or 2, wherein the phosphorescent monomer unit comprises a transition metal complex.
7. An organic light emitting device comprising one or more polymer layers interposed between an anode and a cathode, wherein at least one of the polymer layers comprises the phosphorescent polymer compound according to any one of 1 to 6.
8. The organic light emitting device according to 7, comprising an anode subjected to UV ozone irradiation treatment or high-frequency plasma treatment.
9. The organic light emitting device according to 8, wherein the high-frequency plasma treatment is performed by using a gas containing an organic substance.
10. The organic light emitting device according to 9, wherein the gas containing an organic substance contains at least one of fluorocarbon and methane.
11. The organic light emitting device according to 8, wherein the high-frequency plasma treatment is performed by using a gas containing at least one of oxygen and argon.

### DETAILED DESCRIPTION OF THE INVENTION

An embodiment of the present invention is described below specifically with reference to a drawing.

According to the present invention, there is provided a phosphorescent polymer compound comprising a monomer unit represented by the formula (1) and a phosphorescent monomer unit: 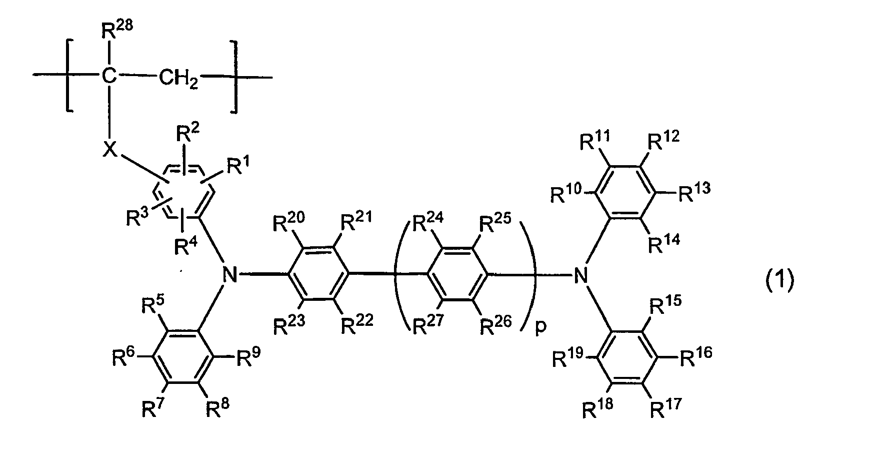 wherein R¹ to R²⁷ independently represent a hydrogen atom, a halogen atom, a cyano group, an amino group, an alkyl group having 1 to 6 carbon atoms, or an alkoxy group having 1 to 6 carbon atoms, groups of R¹ to R¹⁹ connecting to adjacent carbon atoms in the same phenyl group may be bonded together to form a condensed ring; R²⁸ represents a hydrogen atom or an alkyl group having 1 to 6 carbon atoms; X represents a single bond, an oxygen atom (-O-), a sulfur atom (-S-) , -SO-, -SO₂-, -NR- (in which R represents a hydrogen atom, an alkyl group having 1 to 4 carbon atoms, or a phenyl group), -CO-, or a divalent organic group having 1 to 20 carbon atoms, the organic group may be substituted by atom or group selected from the group consisting of an oxygen atom (-O-), a sulfur atom (-S-), -SO-, -SO₂- -NR- (in which R represents a hydrogen atom, an alkyl group having 1 to 4 carbon atoms, or a phenyl group), and -CO-; and p is 0 or 1.

The phosphorescent polymer compound of the present invention is a copolymer containing the monomer unit represented by the formula (1) and a phosphorescent monomer unit. The monomer unit represented by the formula (1) is constituted by a moiety with a triphenylamine structure, a moiety forming a polymeric chain derived from a carbon-carbon double bond, and the linking group X connecting them.

R¹ to R²⁷ in the formula (1) may be a hydrogen atom, a halogen atom, a cyano group, an amino group, an alkyl group having 1 to 6 carbon atoms, or an alkoxy group having 1 to 6 carbon atoms, respectively. Examples of the halogen atoms for R¹ to R²⁷ include a fluorine atom, a chlorine atom, a bromine atom, and an iodine atom. Examples of the alkyl groups having 1 to 6 carbon atoms for R¹ to R²⁷ include a methyl group, an ethyl group, a propyl group, an isopropyl group, a butyl group, an isobutyl group, a tertiary butyl group, an amyl group, and a hexyl group. Examples of the alkoxy groups having 1 to 6 carbon atoms for R¹ to R²⁷ include a methoxy group, an ethoxy group, a propoxy group, an isopropoxy group, an isobutoxy group, and a tertiary butoxy group. Among R¹ to R¹⁹, groups connecting to the adjacent carbon atoms in the same phenyl group may be bonded together to form a condensed ring.

p is 0 or 1.

Preferred examples of the triphenylamine structures in the formula (1) include the structures represented by the formulae (T-1) to (T-11) . 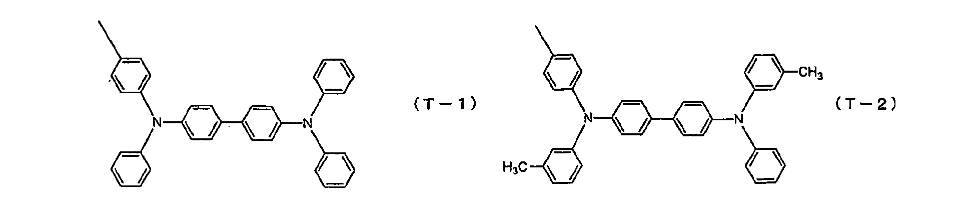 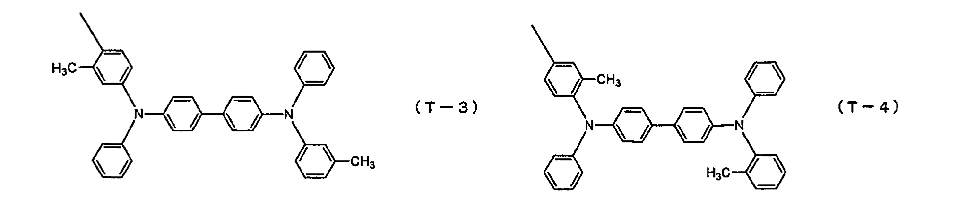 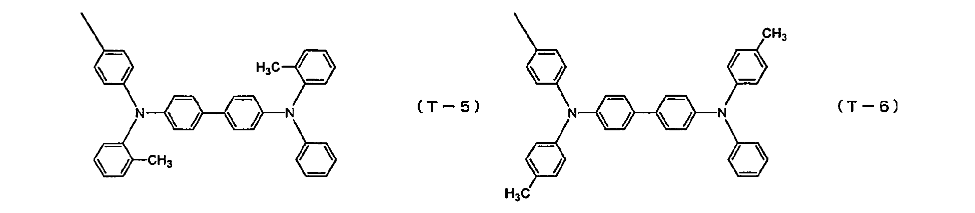 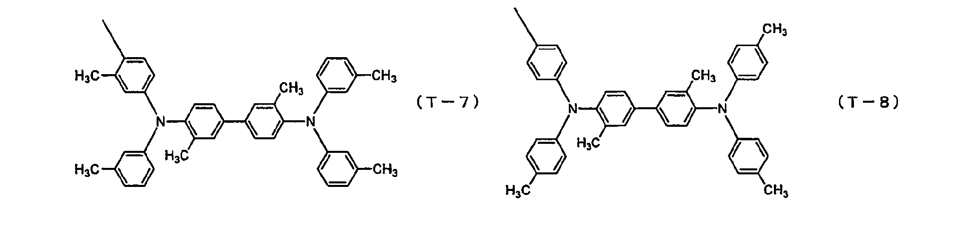 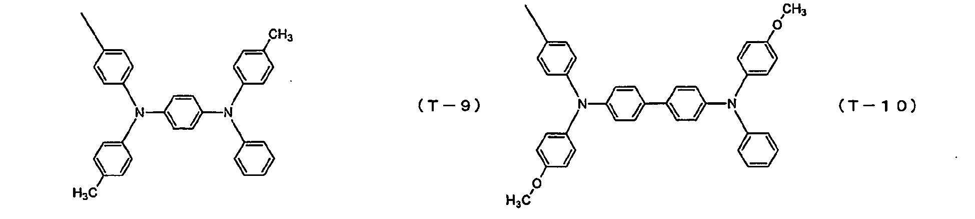 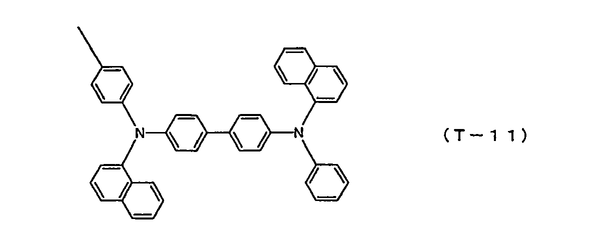 R²⁸ in the formula (1) may be a hydrogen atom or an alkyl group having 1 to 6 carbon atoms. Examples of the alkyl groups having 1 to 6 carbon atoms for R²⁸ include a methyl group, an ethyl group, a propyl group, an isopropyl group, a butyl group, an isobutyl group, a tertiary butyl group, an amyl group and a hexyl group.

The monomer unit of the formula (1) particularly preferably has a structure represented by the formula (2): 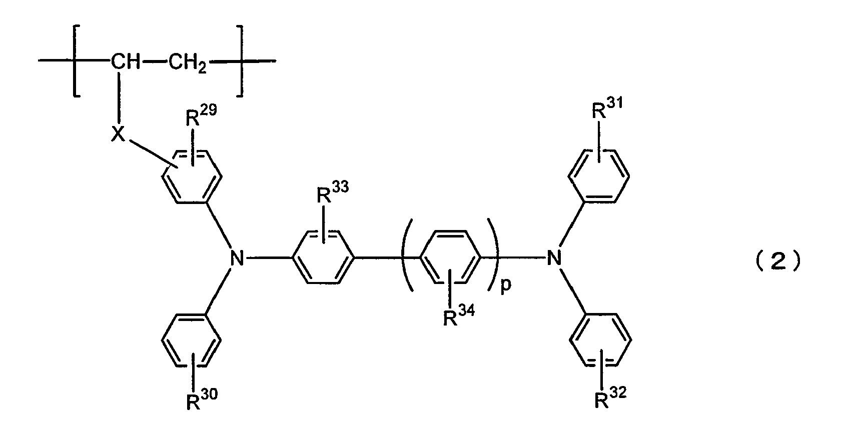 wherein R²⁹ to R³⁴ independently represent a hydrogen atom, an alkyl group having 1 to 6 carbon atoms, or an alkoxy group having 1 to 6 carbon atoms. X represents a single bond, an oxygen atom (-O-), a sulfur atom (-S-), -SO-, -SO₂-, -NR- (in which R represents a hydrogen atom, an alkyl group having 1 to 4 carbon atoms, or a phenyl group), -CO-, or a divalent organic group having 1 to 20 carbon atoms, the organic group may have a substituent atom or group selected from the group consisting of an oxygen atom (-O-), a sulfur atom (-S-), -SO-, -SO₂-, -NR- (in which R represents a hydrogen atom, an alkyl group having 1 to 4 carbon atoms, or a phenyl group), and -CO-; and p is 0 or 1.

The linking group X in the formulae (1) and (2) may be a single bond, an oxygen atom (-O-), a sulfur atom (-S-), -SO-, -SO₂- -NR-(in which R represents a hydrogen atom, an alkyl group having 1 to 4 carbon atoms, or a phenyl group), -CO-, or a divalent organic group having 1 to 20 carbon atoms, and the organic group may be substituted by an atom or group selected from the group consisting of an oxygen atom (-O-), a sulfur atom (-S-) , -SO-, -SO₂-, -NR- (in which R represents a hydrogen atom, an alkyl group having 1 to 4 carbon atoms, or a phenyl group), and -CO-. The monomer unit may contain one or more of the linking groups of the oxygen atom (-O-) , the sulfur atom (-S-) , -SO-, -SO₂-, -NR- (in which R represents a hydrogen atom, an alkyl group having 1 to 4 carbon atoms, or a phenyl group), or -CO-, alone or in combination with the other group. Examples of the linking group X include groups with structures represented by the formulae (S-1) to (S-15).

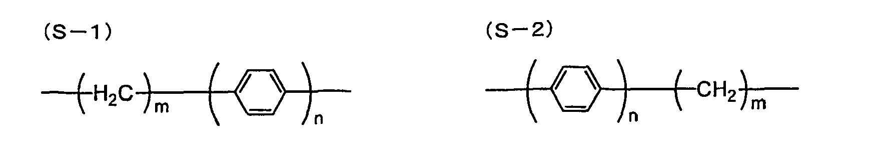

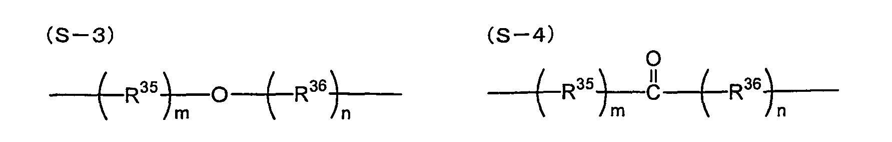

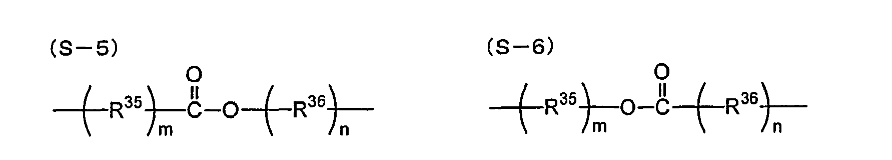

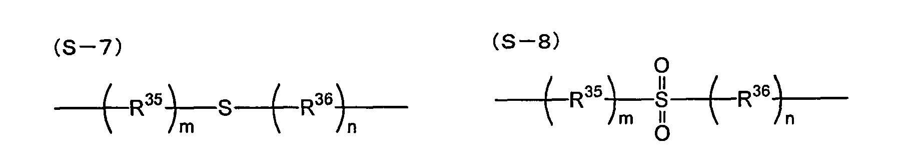

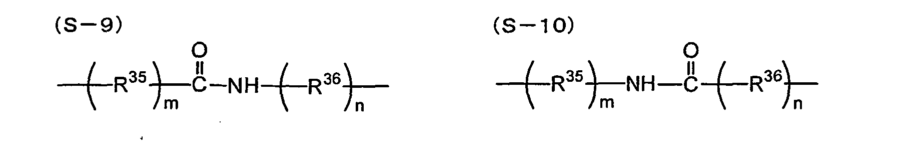

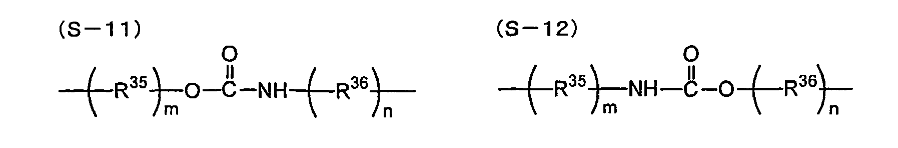

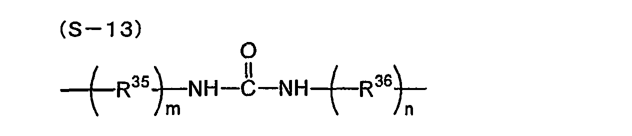

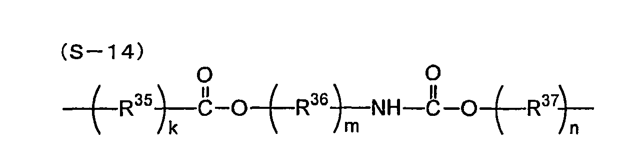

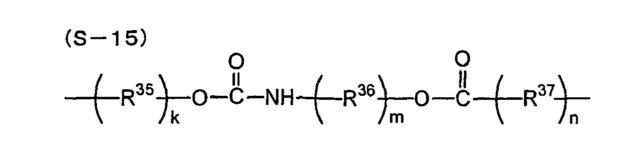

In the formulae, R³⁵, R³⁶ and R³⁷ independently represent a methylene group, or a substituted or unsubstituted phenylene group. k, m and n independently represent 0, 1 or 2.

The phosphorescent monomer unit in the phosphorescent polymer of the present invention is constituted by a phosphorescent moiety, a moiety forming a polymeric chain derived from a carbon-carbon double bond, and a linking group connecting them, and that is, the structure is typically represented by the formula below, 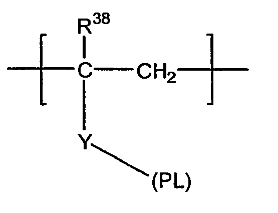 wherein (PL) is a phosphorescent moiety, Y is a linking group with the same meaning as X defined in the formula (1) , and R³⁸ has the same meaning as R²⁸.

The phosphorescent moiety (PL) in the phosphorescent monomer unit may be a monovalent group of a compound capable of phosphorescing at room temperature, and is preferably a monovalent group of a transition metal complex. That is, the phosphorescent moiety may be such that one or more ligands are coordinated to a central atom M and any one of the ligands is connected to the linking group Y. The transition metal (M) used in the transition metal complex is a metal of the first transition element series of Sc with the atomic number 21 to Zn with the atomic number 30, the second transition element series of Y with the atomic number 39 to Cd with the atomic number 48, or the third transition element series of Hf with the atomic number 72 to Hg with the atomic number 80, in the Periodic Table of Elements. Among these transition metals, preferred are Pd, Os, Ir, Pt, and Au, particularly preferred are Ir and Pt.

The ligands of the transition metal complex may be selected from ligands described in G. Wilkinson (Ed.), Comprehensive Coordination Chemistry, Plenum Press, 1987, Akio Yamamoto, Yuki Kinzoku Kagaku Kiso to Oyo, Shokabo Publishing Co., Ltd., 1982, etc. Preferred ligands are halogen ligands; nitrogen-containing heterocyclic ligands such as phenylpyridine ligands, benzothienylpyridine ligands, benzoquinoline ligands, quinolinol ligands, bipyridyl ligands, terpyridine ligands, and phenanthroline ligands; diketone ligands such as acetylacetone ligands and dipivaloylmethane ligands; carboxylic acid ligands such as acetic acid ligands; phosphorus ligands such as triphenylphosphine ligands and phosphite ligands; carbon monoxide ligands; isonitrile ligands; and cyano ligands. Further, pyrazolylborate ligands (such as hydrotrispyrazolylborate and tetrakispyrazolyl borate) may also be used.

Specific examples of the ligands particularly preferred for the transition metal complex include those having the structures of the formulae (L-1) to (L-10).

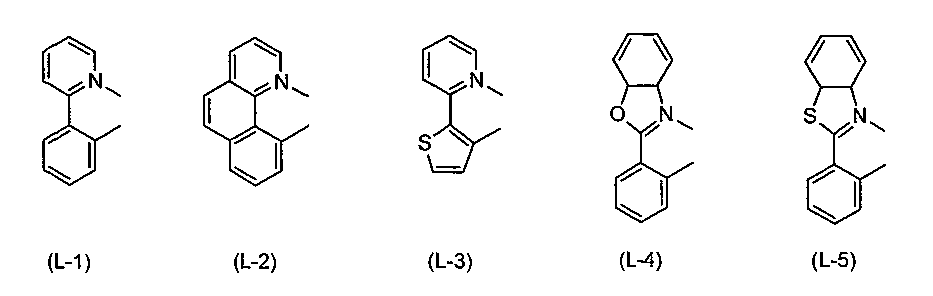

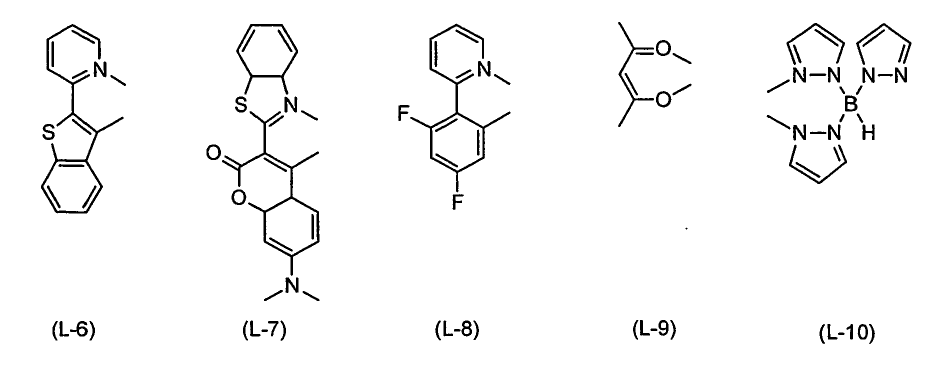

The transition metal complex may contain several types of the ligands. Further, the transition metal complex may be a bi- or poly-nuclear complex.

The linking group (Y) in the phosphorescent monomer unit connects the transition metal complex (PL) to the polymeric chain derived from the carbon-carbon double bond. This linking group may be a single bond, an oxygen atom (-O-), a sulfur atom (-S-), -SO-, -SO₂- -NR- (in which R represents a hydrogen atom, an alkyl group having 1 to 4 carbon atoms, or a phenyl group), -CO-, or a divalent organic group having 1 to 20 carbon atoms, and the organic group may be substituted by an atom or group selected from the group consisting of an oxygen atom (-O-), a sulfur atom (-S-), -SO-, -SO₂-, -NR- (in which R represents a hydrogen atom, an alkyl group having 1 to 4 carbon atoms, or a phenyl group), and -CO-. The divalent organic group having 1 to 20 carbon atoms for the linking group may have a structure of the formulae (S-1) to (S-15) as the linking group X in the formula (1).

The copolymer comprising the monomer unit represented by the formula (1) and the phosphorescent monomer unit may have a monomer arrangement of a random copolymer, a block copolymer, or an alternating copolymer.

The phosphorescent copolymer of the present invention may comprise another monomer unit as the third unit in addition to the monomer unit represented by the formula (1) and the phosphorescent monomer unit. The third monomer unit may be another phosphorescent monomer unit, a hole transporting monomer unit, an electron transporting monomer unit, or a bipolar monomer unit, and is particularly preferably an electron transporting monomer unit.

The electron transporting monomer unit usable as the third monomer unit is constituted by an electron transporting moiety, a moiety forming a polymeric chain derived from a carbon-carbon double bond, and a linking group connecting them.

The electron transporting moiety in the electron transporting monomer unit may be an oxadiazole derivative, a triazole derivative, a triazine derivative, a benzoxazole derivative, an imidazole derivative, a monovalent group of a quinolinol derivative metal complex, etc., and specific examples thereof include the structures represented by the formulae (E-1) to (E-5).

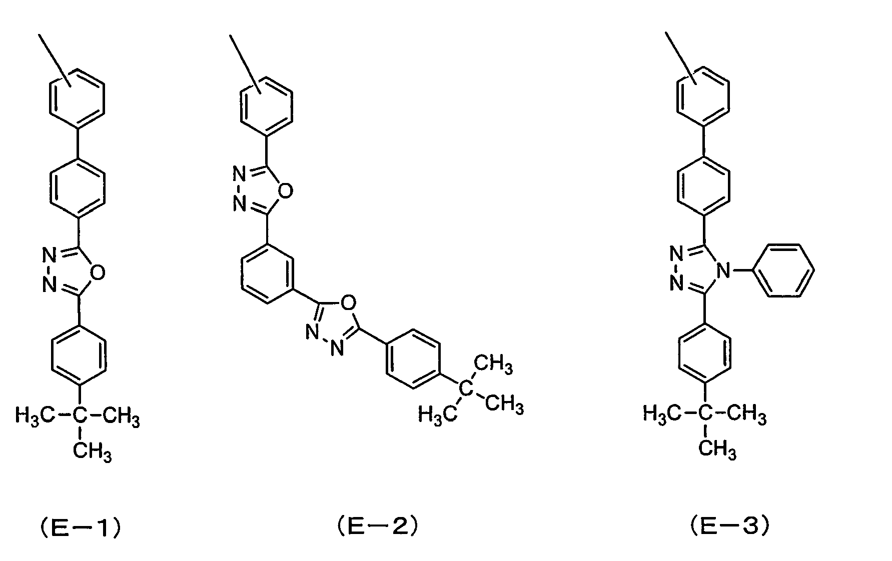

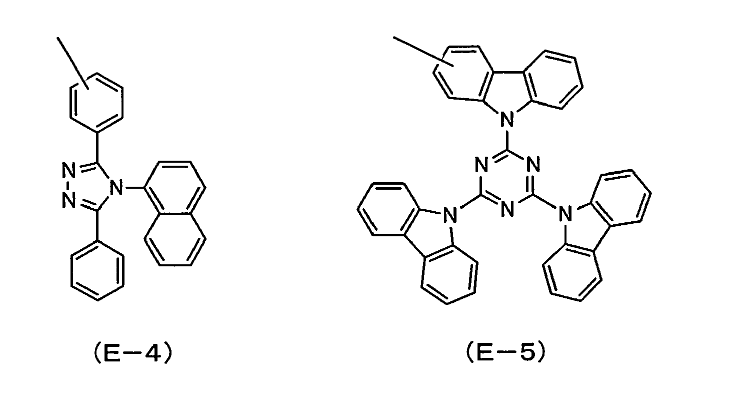

The linking group in the electron transporting monomer unit connects the electron transporting moiety and the polymeric chain derived from the carbon-carbon double bond. This linking group may be a single bond, an oxygen atom (-O-), a sulfur atom (-S-), -SO-, -SO₂- -NR- (in which R represents a hydrogen atom, an alkyl group having 1 to 4 carbon atoms, or a phenyl group), -CO-, or a divalent organic group having 1 to 20 carbon atoms, and the organic group may be substituted by an atom or group selected from the group consisting of an oxygen atom (-O-), a sulfur atom (-S-), -SO-, -SO₂-, -NR- (in which R represents a hydrogen atom, an alkyl group having 1 to 4 carbon atoms, or a phenyl group) , and -CO-. The divalent organic group having 1 to 20 carbon atoms for the linking group may have a structure of the formulae (S-1) to (S-15) as the linking group X in the formula (1).

The polymerization degree of the polymer used in the present invention is preferably 5 to 10,000, more preferably 10 to 5,000.

The molecular weight of the polymer depends on the molecular weights and the polymerization degrees of the monomers constituting the polymer, so that it is difficult to absolutely determine the preferable molecular weight range of the polymer used in the present invention. Suffice it to say that the weight average molecular weight of the polymer of the present invention is preferably 1,000 to 2,000,000, more preferably 5,000 to 1,000,000, independently of the above polymerization degree.

Examples of methods for measuring the molecular weight include methods described in Kobunshi Kagaku no Kiso, Edited by The Society of Polymer Science, Japan, Tokyo Kagaku Dozin Co., Ltd., 1978, such as GPC methods (gel permeation chromatography methods), osmotic pressure methods, light scattering methods, and ultracentrifugal methods.

In the phosphorescent polymer of the present invention, when r represents the repetition number of the phosphorescent monomer units, s represents the repetition number of the carrier transporting monomer units (the total of the repetition numbers of the hole transporting monomer units and the electron transporting monomer units), and each of r and s are an integer of 1 or more, a value r/(r+s), which is a ratio of the repetition number of the phosphorescent monomer units to that of all the monomer units, is desirably 0.0001 to 0.2. Further, the ratio is more desirably 0.001 to 0.1. It should be noted that the monomer unit of the formula (1) is generally a hole transporting monomer unit.

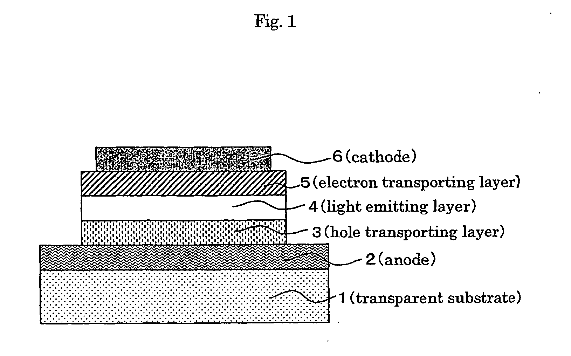

Fig. 1 is a cross-sectional view showing an example of the structure of the organic light emitting device according to the present invention, and the structure is such that a hole transporting layer 3, a light emitting layer 4, and an electron transporting layer 5 are formed in this order between an anode 2 and a cathode 6 disposed on a transparent substrate 1. The structure of the organic light emitting device of the present invention is not limited to the example of Fig. 1, and may have, between an anode and a cathode, 1) a hole transporting layer and a light emitting layer or 2) a light emitting layer and an electron transporting layer, or only one layer of 3) a layer containing a hole transporting material, a light emitting material, and an electron transporting material, 4) a layer containing a hole transporting material and a light emitting material, 5) a layer containing a light emitting material and an electron transporting material, or 6) a layer containing only a light emitting material. Further, the organic light emitting device may have two or more light emitting layers though the structure shown in Fig. 1 has one light emitting layer.

In the organic light emitting device of the present invention, the light emitting layer may be composed of only the above-described phosphorescent polymer compound. Further, the light emitting layer may be composed of a composition prepared by mixing the phosphorescent polymer compound with another carrier transporting compound to cover the carrier transporting properties of the phosphorescent polymer compound. Thus, a hole transporting compound may be added to cover the hole transporting properties of the phosphorescent polymer compound of the present invention, and an electron transporting compound may be added to cover the electron transporting properties. The carrier transporting compound to be mixed with the phosphorescent polymer compound may be a low or high molecular weight compound.

Examples of the low molecular weight hole transporting compounds to be mixed with the phosphorescent polymer compound include triphenylamine derivatives such as TPD (N,N'-bis(3-methylphenyl)-N,N'-diphenylbenzidine), α-NPD (4,4'-bis[N-(1-naphthyl)-N-phenylamino]biphenyl), and m-MTDATA (4,4',4" -tris(3-methylphenylphenylamino)triphenylamine), etc. Examples of the high molecular weight hole transporting compounds mixed with the phosphorescent polymer compound include polyvinylcarbazoles and polymers produced by introducing a polymerizable functional group into a triphenylamine-based low molecular weight compound such as polymer compounds with triphenylamine structures disclosed in JP-A-8-157575.

Examples of the low molecular weight electron transporting compounds to be mixed with the phosphorescent polymer compound include quinolinol derivative metal complexes such as Al(q)₃ (tris(quinolinol)aluminum, q representing quinolinol or a derivative thereof), oxadiazole derivatives, triazole derivatives, imidazole derivatives and triazine derivatives. Examples of the high molecular weight electron transporting compounds to be mixed with the phosphorescent polymer compound include polymers produced by introducing a polymerizable functional group into the above low molecular weight electron transporting compound such as poly(PBD) disclosed in JP-A-10-1665.

Further, for the purpose of improving the physical properties, etc. of the film formed of the phosphorescent polymer compound, a polymer compound having no direct effect on the light emitting properties of the phosphorescent polymer compound may be added and thus-obtained composition may be used as a light emitting material. For example, PMMA (polymethyl methacrylate) may be added to make the resultant film flexible.

In the organic light emitting device of the present invention, examples of the hole transporting materials forming the hole transporting layer include triphenylamine derivatives such as TPD (N,N'-bis(3-methylphenyl)-N,N'-diphenylbenzidine), α-NPD (4,4'-bis[N-(1-naphthyl)-N-phenylamino]biphenyl), and m-MTDATA (4,4',4" -tris(3-methylphenylphenylamino)triphenylamine), and polyvinylcarbazoles. The examples further include polymers produced by introducing a polymerizable functional group into a triphenylamine-based low molecular weight compound such as polymer compounds with a triphenylamine skeleton disclosed in JP-A-8-157575, and polymer materials such as poly(para-phenylenevinylene) and polydialkylfluorene. These hole transporting materials may be used singly, or mixed or layered with other hole transporting materials. The thickness of the hole transporting layer is preferably 1 nm to 5 µm, more preferably 5 nm to 1 µm, further preferably 10 nm to 500 nm, though not particularly restricted.

In the organic light emitting device of the present invention, examples of the electron transporting materials forming the electron transporting layer include quinolinol derivative metal complexes such as Al(q)3 (tris(quinolinol)aluminum), oxadiazole derivatives, triazole derivatives, imidazole derivatives, and triazine derivatives. Further, the electron transporting material may be a polymer produced by introducing a polymerizable functional group into the above-mentioned low molecular weight electron transporting compound, such as poly(PBD) (2-(4-tert-buthylphenyl)-5-(4-biphenylyl)-1,3,4-oxadiazole) disclosed in JP-A-10-1665. These electron transporting materials may be used singly, or mixed or layered with other electron transporting materials. The thickness of the electron transporting layer is preferably 1 nm to 5 µm, more preferably 5 nm to 1 µm, further preferably 10 nm to 500 nm, though not particularly restricted.

Each of the phosphorescent polymer compound for the light emitting layer, the hole transporting material for the hole transporting layer, and the electron transporting material for the electron transporting layer may be formed into the layer, singly or by using a polymer material as a binder. Examples of the polymer materials for the binder include polymethyl methacrylates, polycarbonates, polyesters, polysulfones and polyphenylene oxides.

The light emitting layer, the hole transporting layer, and the electron transporting layer can be formed by a resistance heating deposition method, an electron beam deposition method, a sputtering method, an ink-jet method, a spin coating method, a printing method, a spray method, a dispenser method, etc. In case of using low molecular weight compounds to form a layer, dominantly employed are resistance heating deposition method and the electron beam deposition method, and In case of using high molecular weight, dominantly employed are ink-jet method, the printing method, and the spin coating method.

For the purpose of efficiently recombine holes with electrons in the light emitting layer, a hole blocking layer may be disposed on the cathode side of the light emitting layer in order that holes can be prevented from passing through the light emitting layer. Examples of materials for the hole blocking layer include triazole derivatives, oxadiazole derivatives and phenanthroline derivatives.

The anode of the organic light emitting device of the present invention may comprise a known transparent conductive material, and examples of the materials include ITO (indium tin oxide), tin oxide, zinc oxide, and conductive polymers such as polythiophenes, polypyrroles and polyanilines. The electrode comprising the transparent conductive material preferably has a surface resistance of 1 to 50 Ω/square. The materials may be formed into a film by an electron beam deposition method, a sputtering method, a chemical reaction method, a coating method, etc. The anode preferably has a thickness of 50 to 300 nm.

An anode buffer layer may be disposed between the anode and the hole transporting layer or an organic layer adjacent to the anode to buffer the injection barrier for the holes. Copper phthalocyanine, a mixture of polyethylene dioxythiophene (PEDOT) and polystyrene sulfonate (PPS), etc. can be used for the buffer layer. The anode may be subjected to various surface treatments before use. The "anode surface treatment" herein referred to is performed after an anode is formed on a transparent substrate. Specific examples of surface treatments employed herein include UV ozone irradiation treatment and high-frequency plasma treatment. Further, examples of high-frequency plasma treatment include (1) coating treatment or etching treatment which uses a gas containing fluorocarbon or methane, and (2) etching treatment which uses an oxygen gas or an argon gas. The anode may be subjected to one or more selected from the above treatment methods, and in a case where two or more of the treatments are performed, the order of the treatments is not limited.

The coating treatment using high-frequency plasma mentioned herein is also referred to as "plasma polymerization method". The treatment degree in coating treatment or etching treatment can be controlled by adjusting treatment conditions such as temperature, voltage and degree of vacuum. Specifically, in case of coating treatment, film thickness of the coating formed, film properties such as water-shedding property, peel strength and hardness can be controlled, and in case of etching treatment, the treatment degree may be controlled through degrees of washing the surface, smoothing the surface and corroding the surface.

In the organic light emitting device of the present invention, the anode surface is preferably treated with high frequency plasma treatment, most preferably with plasma polymerization treatment using fluorocarbon gas.

In the organic light emitting device of the present invention, it is preferable that a material having a small work function, for example, alkaline metals such as Li and K and alkaline earth metals such as Mg, Ca, and Ba be used as cathode material, from the viewpoint of the electron injection efficiency. It is also preferable that as materials chemically more stable than the above materials, Al, an Mg-Ag alloy, an Al-alkaline metal alloy such as an Al-Li alloy and an Al-Ca alloy, etc., be used as cathode material. To achieve both of the electron injection efficiency and the chemical stability, a thin layer of an alkaline or alkaline earth metal such as Cs, Ca, Sr, and Ba having a thickness of approximately 0.01 to 10 µm may be disposed below the Al layer (assuming that the cathode is on the upper side while the anode on the lower side), as described in JP-A-2-15595 and JP-A-5-121172. The cathode can be formed from the material by a resistance heating deposition method, an electron beam deposition method, a sputtering method, an ion plating method, etc. The thickness of the cathode is preferably 10 nm to 1 µm, more preferably 50 to 500 nm.

In the organic light emitting device of the present invention, the substrate may be an insulating substrate transparent against the emission wavelength of the light emitting material. Glasses and transparent plastics including PET (polyethylene terephthalate), polycarbonate, and PMMA (polymethyl methacrylate) can be used for the substrate.

### BRIEF DESCRIPTION OF DRAWINGS

Fig.1 is a cross-sectional view showing an example of the organic light emitting device.

### BEST MODE FOR CARRYING OUT THE PRESENT INVENTION

The present invention will be explained in more detail below referring to typical examples. The examples are considered in all respects to be illustrative, and the present invention is not restricted thereto.
Measuring apparatuses used in the examples are as follows.
1) ¹H-NMR and ¹³C-NMR
   JNM EX270 manufactured by JEOL Ltd.
   270 Mz
   Solvent: Chloroform-d
2) GPC measurement (molecular weight measurement)
   Column: Shodex KF-G + KF804L + KF802 + KF801
   Eluent: Tetrahydrofuran (THF)
   Temperature: 40°C
   Detector: RI (Shodex RI-71)
3) ICP elemental analysis
   *ICPS 8000 manufactured by Shimadzu Corporation*

### Example 1: Synthesis of Polymerizable compound viTPD (1-1)

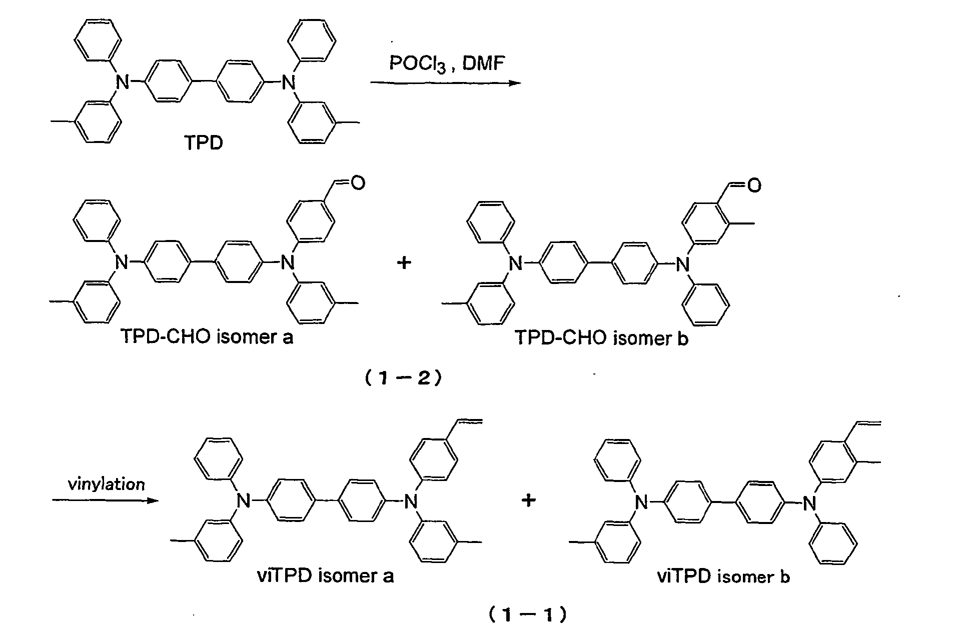

A polymerizable group (a vinyl group) was bonded to TPD (N,N'-bis(3-methylphenyl)-N,N'-diphenylbenzidine) by the following procedures to synthesize the compound (1-1), hereinafter referred to as viTPD.

### (1) Formylation of TPD

Under an argon atmosphere, 11.2 ml of phosphorus oxychloride was added to 200 ml of dry N,N-dimethylformamide and stirred for 30 minutes, and then 51.7 g of N,N'-bis(3-methylphenyl)-N,N'-diphenylbenzidine(TPD) was added thereto and stirred at 80°C for 2 hours. After the reaction, the reaction liquid was added dropwise to 2.5 L of a 1. 0 M aqueous sodium carbonate solution, and the generated precipitates were separated by filtration. The precipitates were dissolved in 500 ml of dichloromethane, and 500 ml of pure water was added to the resultant. The organic layer was dried over magnesium sulfate, concentrated under a reduced pressure, and purified by a silica gel column chromatography using a developing solvent of a dichloromethane-hexane mixed solvent. The solvent was distilled off to obtain 21.6 g of a yellow solid of TPD-CHO (1-2) with a yield of 40%. As a result of ¹H-NMR identification, it was found that the product was a mixture of two different isomers a and b. It was estimated from integral values of the ¹H-NMR spectrum that the ratio of the isomer a/the isomer b was 28/72.
¹H-NMR (270 MHz, CDCl₃, ppm): 10.06 (s, 1H, -CHO (isomer b)), 9.82 (s, 1H, -CHO (isomer a)), 7.7-6.8 (m, 25H, ArH (isomers a and b) ) , 2.54 (s, 3H, -CH₃ (isomer b)), 2.32 (s, 3H, -CH₃ (isomer a)), 2.28 (s, 3H, -CH₃ (isomers a and b)).

### (2) Vinylation of TPD-CHO

Under an argon atmosphere, 100 ml of dry benzene and 50 ml of dry THF were added to 7.86 g of methyltriphenylphosphonium bromide and cooled to 0°C. Thereto was added 13.8 ml of a 1.6 M butyl lithium hexane solution dropwise using a syringe, and stirred for 10 minutes to obtain a phosphorane solution. Under an argon atmosphere, to 10. 89 g of TPD-CHO (1-2) was added 100 ml of dry benzene, and then thereto was added the above phosphorane solution using a syringe. The reaction liquid was stirred at the room temperature for 2 hours to carry out the reaction. The reaction liquid was analyzed by TLC, and as a result, the starting material of TPD-CHO remained in the liquid. Thus, a solution equal to the above phosphorane solution was added to the liquid in the half amount and stirred at the room temperature for 2 hours. To the reaction liquid were added pure water and dichloromethane, and the water layer was subjected to extraction with dichloromethane 2 times. The organic layer was dried over magnesium sulfate, concentrated under a reduced pressure, and purified by a silica gel column chromatography using a developing solvent of a dichloromethane-hexane mixed solvent. The resultant was freeze-dried from a benzene solution to obtain 8.26 g of the desired product with a yield of 72%. As a result of ¹H-NMR identification, it was found that the product was a mixture (1-1) of two different viTPD isomers a and b.
¹H-NMR (270 MHz, CDCl₃ ppm): 7.5-6.8 (m, 25H (isomers a and b) + 1H (isomer b), ArH (isomers a and b) + -CH=CH₂ (isomer b)), 6.67 (dd, 1H, J= 17.4, 11.2 Hz, -CH=CH₂ (isomer a)), 5.64 (d, 1H, J= 17.8 Hz, -CH=CH₂ (cis) (isomer a)), 5.58 (d, 1H, J=17.6Hz, -CH=CH₂ (cis) (isomer b)), 5.21 (d, 1H, J = 11.1 Hz, -CH=CH₂ (trans) (isomer b)), 5.16 (d, 1H, J = 15.4 Hz, -CH=CH₂ (trans) (isomer a)), 2.26 (s, 6H, -CH₃ (isomers a and b)).

### Example 2: Synthesis of polymerizable compound viPMTPD (2-1)

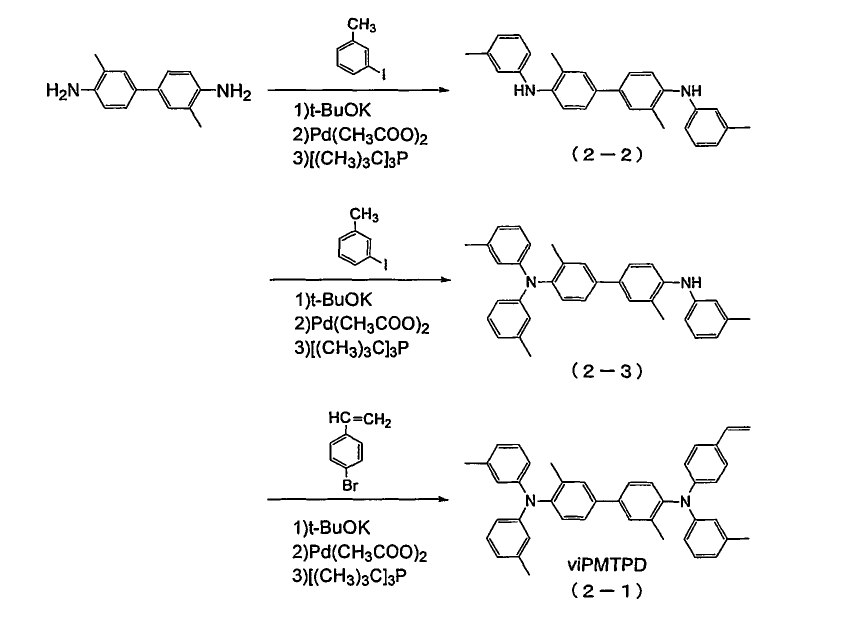

### (1) Ditolylation of 3,3'-dimethylbenzidine

Under an argon atmosphere, 80 ml of dry xylene was added to 5 g of 3,3'-dimethylbenzidine and 11. 30 g of 3-iodotoluene, and heated to about 50°C. Thereto were added 6.82 g of potassium tert-butoxide, 230 mg of palladium acetate, and 460 mg of tri-tert-butylphosphine in this order, and the resulting mixture was stirred at 120°C for 4 hours. The reaction liquid was cooled to the room temperature, thereto was added 50 ml of pure water, and then the liquid was extracted with ethyl acetate 2 times. The organic layer was dried over magnesium sulfate, concentrated under a reduced pressure, and purified by a silica gel column chromatography using a developing solvent of an ethyl acetate-hexane mixed solvent. After the solvent was distilled off, the residue was recrystallized from methanol to obtain 4.00 g of 3,3'-dimethyl-N,N'-di-m-tolylbenzidine (2-2) with a yield of 49%. The product was identified by ¹H-NMR.
¹H-NMR (270 MHz, CDCl₃, ppm): 7.42 (d, 2H, J = 1.6 Hz, ArH), 7.36 (dd, 2H, J = 8.2, 2.0 Hz, ArH), 7.28 (d, 2H, J = 8.1 Hz, ArH), 7.16 (t, 2H, J = 8.0 Hz, ArH), 6.81 (m, 4H, ArH), 6.73 (d, 2H, J = 7.6 Hz, ArH), 5.37 (s, 2H, -NH), 2.31 (s, 12H, -CH₃).

### (2) Tolylation of 3,3'-dimethyl-N,N'-di-m-tolylbenzidine

Under an argon atmosphere, 50 ml of dry xylene was added to 4.00 g of 3,3'-dimethyl-N,N'-di-m-tolylbenzidine (2-2) and 2.64 g of 3-iodobenzene, and heated to about 50°C. Thereto were added 1.27 g of potassium tert-butoxide, 225 mg of palladium acetate, and 200 mg of tri-tert-butylphosphine in this order, and the resulting liquid was stirred at 120°C for 4 hours. The reaction liquid was cooled to the room temperature, thereto was added 30 ml of pure water, and then the liquid was subjected to extraction with ethyl acetate 2 times. The organic layer was dried over magnesium sulfate, concentrated under a reduced pressure, and purified by a silica gel column chromatography using a developing solvent of a toluene-hexane mixed solvent. After the solvent was distilled off, the residue was recrystallized from hexane to obtain 3.37 g of 3, 3' -dimethyl-N, N, N' -tri-m-tolylbenzidine (2-3) with a yield of 70%. The product was identified by ¹H-NMR.
¹H-NMR (270 MHz, CDCl₃ ppm): 7.45 (d, 2H, J = 2.7 Hz, ArH), 7.43 (d, 2H, J=8.1Hz, ArH), 7.4-7.0 (m, 6H, ArH), 6.9-6.7 (m, 8H, ArH), 5.40 (s (br), 1H, -NH), 2.32 (s, 6H, -CH₃), 2.25 (s, 6H, -CH₃), 2.08 (s, 3H, -CH₃).

### (3) Styrylation

Under an argon atmosphere, 20 ml of dry toluene was added to 1. 93 g of 3,3'-dimethyl-N,N,N'-tri-m-tolylbenzidine (2-3) and 589 mg of potassium tert-butoxide, thereto were added 0.58 ml of 4-bromostyrene, 9.0 mg of palladium acetate, and 28.3 mg of tri-tert-butylphosphine in this order, and the resulting mixture was refluxed for 3.5 hours while stirring. The mixture was cooled to the room temperature, thereto were added 20 ml of pure water and 20 ml of ethyl acetate, and the water layer was subjected to extraction with dichloromethane 2 times. The organic layer was dried over magnesium sulfate, concentrated under a reduced pressure, and purified by a silica gel column chromatography using a developing solvent of a toluene-hexane mixed solvent. After the solvent was distilled off, the residue was freeze-dried from benzene to obtain 1. 66 g of a white solid of viPMTPD (2-1) with a yield of 71%. The product was identified by ¹H-NMR.
¹H-NMR (270 MHz, CDCl₃ ppm): 7.5-6.7 (m, 22H, ArH), 6.65 (dd, 1H, J=17.4, 10.9Hz, -CH=CH₂), 5.61 (d, 1H, J=17.6Hz, -CH=CH₂ (cis)), 5.12(d, 1H, J = 11.1 Hz, -CH=CH₂ (trans)), 2.25 (s, 9H, -CH₃), 2.08 (s, 6H, -CH₃).

### Example 3: Synthesis of copolymer poly-(ViTPD-co-IrST)

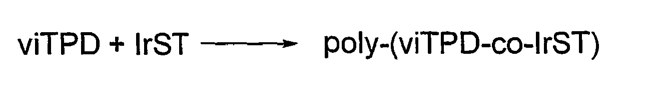

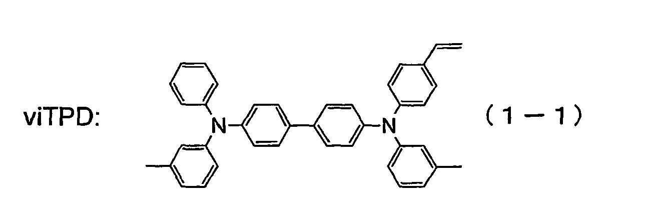

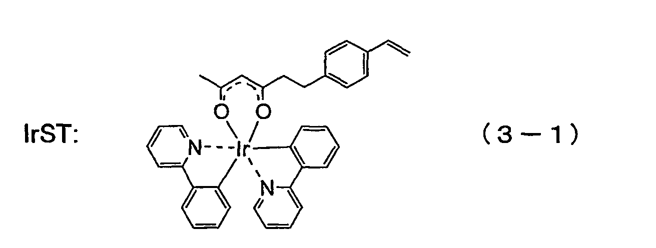

920 mg of viTPD (1-1) produced in Example 1 and 80 mg of IrST (formula (3-1), synthesized according to a method described in JP-A-2003-113246) were placed in an airtight vessel, and thereto was added 9.0 ml of dry toluene. To this was added 181 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 72 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 750 mg of a pale yellow solid of poly- (viTPD-co- IrST). By GPC measurement, it was estimated that the obtained copolymer had a number average molecular weight (Mn) of 19,700, a weight average molecular weight (Mw) of 50,300, and a molecular weight distribution index (Mw/Mn) of 2.55, in terms of polystyrene. The iridium content of the copolymer, measured by the ICP elemental analysis, was 1.5 mass%. Thus, it was estimated that the copolymer had a copolymerization mass ratio viTPD/IrST of 94.4/5.6.

### Example 4: Synthesis of copolymer poly-(viPMTPD-co-IrST)

viPMTPD + IrST → poly-(viPMTPD-co-IrST)

920 mg of viPMTPD (2-1) produced in Example 2 and 80 mg of IrST (3-1) were placed in an airtight vessel, and thereto was added 8.4 ml of dry toluene. To this was added 169 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 72 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 812 mg of a pale yellow solid of poly-(viPMTPD-co-IrST). By GPC measurement, it was estimated that the obtained copolymer had a number average molecular weight (Mn) of 24,300, a weight average molecular weight (Mw) of 59,400, and a molecular weight distribution index (Mw/Mn) of 2.44, in terms of polystyrene. The iridium content of the copolymer, measured by the ICP elemental analysis, was 1.6 mass%. Thus, it was estimated that the copolymer had a copolymerization mass ratio viPMTPD/IrST of 94.0/6.0.

### Example 5: Synthesis of copolymer poly-(viTPD-co-viPBD-co-IrST)

viTPd + viPBD + IrST → poly-(viTPD-co-viPBD-co-IrST)

viTPD: 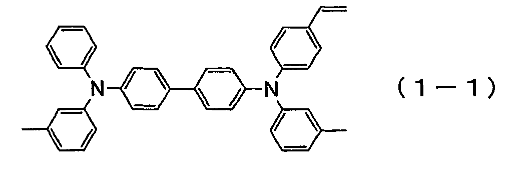 viPBD: 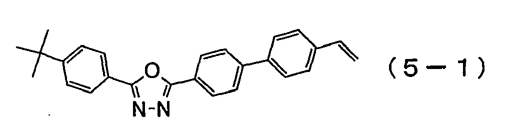 IrST:

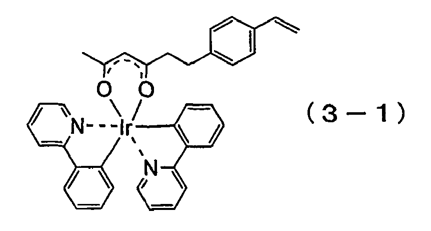

460 mg of viTPD (1-1) , 460 mg of viPBD ((5-1), synthesized according to a method described in JP-A-10-1665), and 80 mg of IrST (3-1) were placed in an airtight vessel, and thereto was added 10.8 ml of dry toluene. To this was added 217 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 96 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 789 mg of a pale yellow solid of poly-(viTPD-co-viPBD-co-IrST). By GPC measurement, it was estimated that the obtained copolymer had a number average molecular weight (Mn) of 21,400, a weight average molecular weight (Mw) of 46,600, and a molecular weight distribution index (Mw/Mn) of 2.17, in terms with polystyrene. The iridium content of the copolymer, measured by the ICP elemental analysis, was 1. 5 mass%. From the iridium content and ¹³C-NMR measurement results, it was estimated that the copolymer had a copolymerization mass ratio viTPD/viPBD/IrST of 43.1/51.3/5.6.

### Example 6: Synthesis of copolymer poly-(viPMTPD-co-viPBD-co-IrST)

viMTPD + viPBD + IrST → poly-(viPMTPD-co-viPBD-co-IrST)

viPMTPD:

460 mg of viPMTPD (2-1), 460 mg of viPBD (5-1), and 80 mg of IrST (3-1) were placed in an airtight vessel, and thereto was added 10.5 ml of dry toluene. To this was added 211 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 96 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 810 mg of a pale yellow solid of poly- (viPMTPD-co-viPBD-co-IrST) . By GPC measurement, it was estimated that the obtained copolymer had a number average molecular weight (Mn) of 26,600, a weight average molecular weight (Mw) of 62,200, and a molecular weight distribution index (Mw/Mn) of 2.34, in terms of polystyrene. The iridium content of the copolymer, measured by the ICP elemental analysis, was 1.5 mass%. From the iridium content and ¹³C-NMR measurement results, it was estimated that the copolymer had a copolymerization mass ratio viPMTPD/viPBD/IrST of 44.2/50.2/5.6.

### Example 7: Synthesis of copolymer poly-(viTPD-co-viOXD7-co-IrST)

viTPD + viOXD7 + IrST → poly-(viTPD-co-viOXD7-co-IrST)

viTPD: 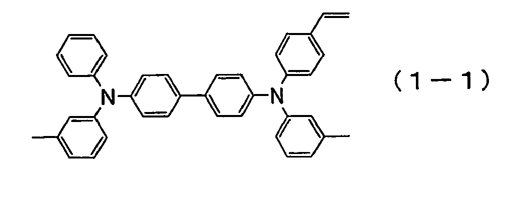 viOXD7: 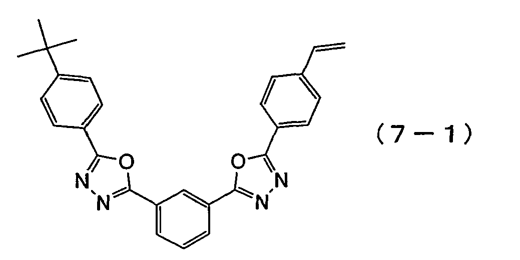 IrST:

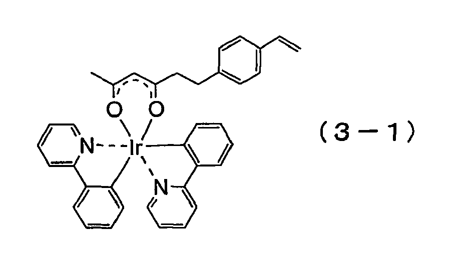

460 mg of viTPD (1-1), 460 mg of viOXD7 (7-1), and 80 mg of IrST (3-1) were placed in an airtight vessel, and thereto was added 11.7 ml of dry toluene. To this was added 235 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 96 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 750 mg of a pale yellow solid of poly- (viTPD-co-viOXD7-co-IrST). By GPC measurement, it was estimated that the obtained copolymer had a number average molecular weight (Mn) of 19,700, a weight average molecular weight (Mw) of 67,300, and a molecular weight distribution index (Mw/Mn) of 3.42, in terms of polystyrene. The iridium content of the copolymer, measured by the ICP elemental analysis, was 1.5 mass%. From the iridium content and ¹³C-NMR measurement results, it was estimated that the copolymer had a copolymerization mass ratio viTPD/viOXD7/IrST of 46.4/48.0/5.6.

### Example 8: Synthesis of copolymer poly-(viTPD-co-viPBD-co-IrST (R))

viTPD + viPBD + IrST → poly-(viTPD-co-viPBD-co-IrST(R))

viTPD: 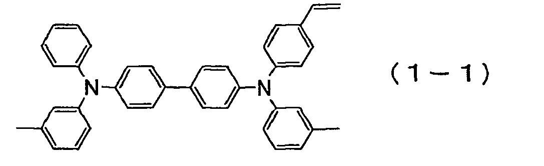 viPBD: 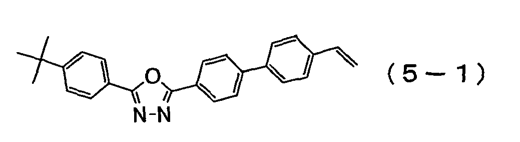 IrST(R):

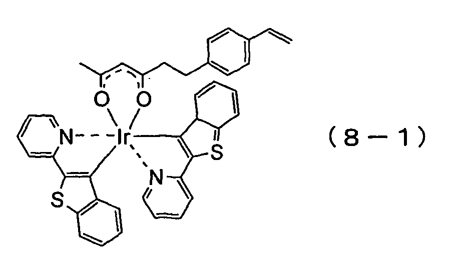

460 mg of viTPD (1-1) , 460 mg of viPBD (5-1), and 80 mg of IrST (R) (8-1) (synthesized according to a method described in JP-A-2003-147021) were placed in an airtight vessel, and thereto was added 10.8 ml of dry toluene. To this was added 215 µl of a 0.1 M toluene solution of V-601 manufactured by Wako Pure Chemical Industries, Ltd., and the resulting liquid was subjected to freeze deaeration 5 times. The vessel was closed under vacuum, and the liquid was stirred at 60°C for 96 hours. After the reaction, the reaction liquid was added to 300 ml of acetone dropwise to generate precipitates. The precipitates were purified by repeating reprecipitation in a toluene-acetone solvent 2 times, and vacuum-dried at 50°C overnight, to obtain 773 mg of a pale red solid of poly- (viTPD-co-viPBD-co-IrST (R)) . By GPC measurement, it was estimated that the obtained copolymer had a number average molecular weight (Mn) of 22,100, a weight average molecular weight (Mw) of 50,100, and a molecular weight distribution index (Mw/Mn) of 2.27, in terms of polystyrene. The iridium content of the copolymer, measured by the ICP elemental analysis, was 1.6 mass%. From the iridium content and ¹³C-NMR measurement results, it was estimated that the copolymer had a copolymerization mass ratio viTPD/viPBD/IrST (R) of 42.9/50.2/6.9.

### Example 9: Synthesis of polymerizable compound viMeOTPD (9-1)

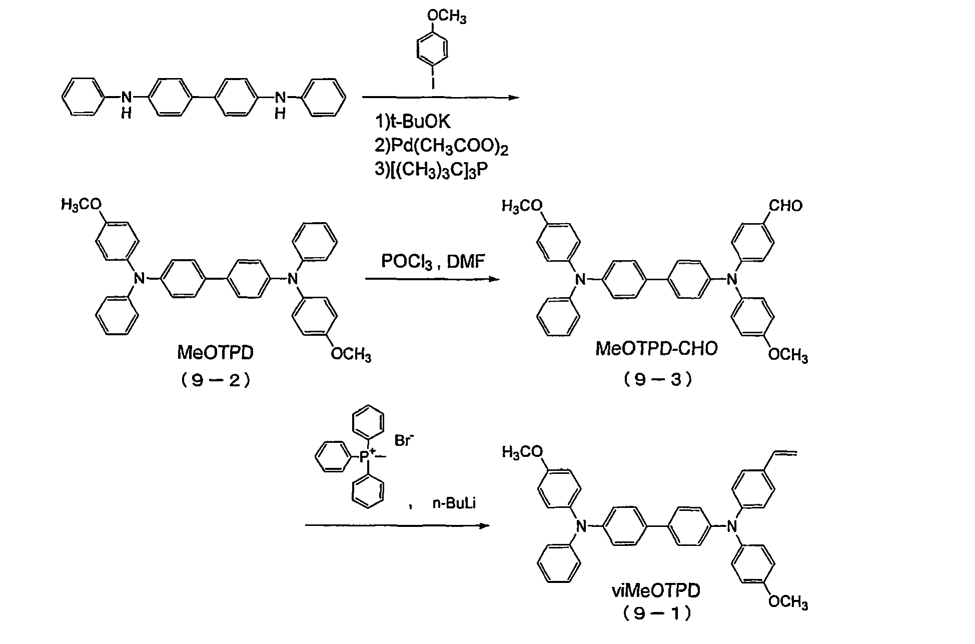

### (1) Bis-methoxyphenylation of N,N'-diphenylbenzidine

Under an argon atmosphere, 160 ml of dry toluene was added to 11.30 g of N,N'-diphenylbenzidine and 17.30 g of 4-iodoanisole, and heated to about 50°C. Thereto were added 9.05 g of potassium tert-butoxide, 302 mg of palladium acetate, and 816 mg of tri-tert-butylphosphine in this order, and the resulting mixture was refluxed for 4 hours while stirring. The reaction liquid was cooled to the room temperature, thereto was added 100 ml of pure water, and then the liquid was extracted with ethyl acetate 2 times. The organic layer was dried over magnesium sulfate, concentrated under a reduced pressure, and purified by a silica gel column chromatography using a developing solvent of an ethyl acetate-hexane mixed solvent. After the solvent was distilled off, the residue was recrystallized from hexane to obtain 11.98 g of MeOTPD (9-2) with a yield of 65%. The product was identified by ¹H-NMR.
¹H-NMR (270 MHz, CDCl₃, ppm): 7.40 (d, 4H, J = 8.6 Hz, ArH), 7.21 (d, 4H, J = 7.3 Hz, ArH), 7.2-7.0 (m, 12H, ArH), 6.95 (t, 2H, J = 7.4, ArH), 6.85 (d, 4H, J = 8.9 Hz, ArH), 3.81 (s, 6H, -OCH₃).

### (2) Formylation of MeOTPD

Under an argon atmosphere, 1.12 ml of phosphorus oxychloride was added to 20 ml of dry N,N-dimethylformamide and stirred for 30 minutes, and then 5.49 g of MeOTPD (9-2) was added thereto and stirred at 80°C for 2 hours. After the reaction, the reaction liquid was added dropwise to 250 ml of a 1.0 M aqueous sodium carbonate solution, and the generated precipitates were separated by filtration. The precipitates were dissolved in 50 ml of dichloromethane, and 50 ml of pure water was added to the resultant. The organic layer was dried over magnesium sulfate, concentrated under a reduced pressure, and purified by a silica gel column chromatography using a developing solvent of a dichloromethane-hexane mixed solvent. The solvent was distilled off to obtain 2.65 g of a yellow solid of MeOTPD-CHO (9-3) with a yield of 46%. The product was identified by ¹H-NMR.
¹H-NMR (270 MHz, CDCl₃, ppm) : 10.08 (s, 1H, -CHO), 7.7-6.8 (m, 25H, ArH), 3.85 (s, 6H, -OCH₃).

### (3) Vinylation of MeOTPD-CHO

Under an argon atmosphere, 20 ml of dry benzene and 10 ml of dry THF were added to 2.14 g of methyltriphenylphosphonium bromide and cooled to 0°C. Thereto was added 3.75 ml of a 1.6 M butyl lithium hexane solution dropwise using a syringe, and stirred for 10 minutes to obtain a phosphorane solution. Under an argon atmosphere, to 2.31 g of MeOTPD-CHO (9-3) was added 20 ml of dry benzene, and then thereto was added the above phosphorane solution using a syringe. The reaction liquid was stirred at the room temperature for 2 hours, thereto were added 20 ml of pure water and dichloromethane, and the water layer was subjected to extraction with dichloromethane 2 times. The organic layer was dried over magnesium sulfate, concentrated under a reduced pressure, and purified by a silica gel column chromatography using a developing solvent of a dichloromethane-hexane mixed solvent. The resultant was freeze-dried from a benzene solution to obtain 1.72 g of viMeOTPD with a yield of 75%. The product was identified by ¹H-NMR.
¹H-NMR (270 MHz, CDCl₃ ppm): 7.5-6.8 (m, 25H, ArH), 6.65 (dd, 1H, J= 17. 6, 10. 9 Hz, -CH=CH₂), 5.62 (d, 1H, J= 17.3 Hz, -CH=CH₂ (cis)), 5.12 (d, 1H, J = 11.1 Hz, -CH=CH₂ (trans)), 3.80 (s, 6H, -OCH₃).

### Example 10: Synthesis of polymerizable compound viNPD (10-1)

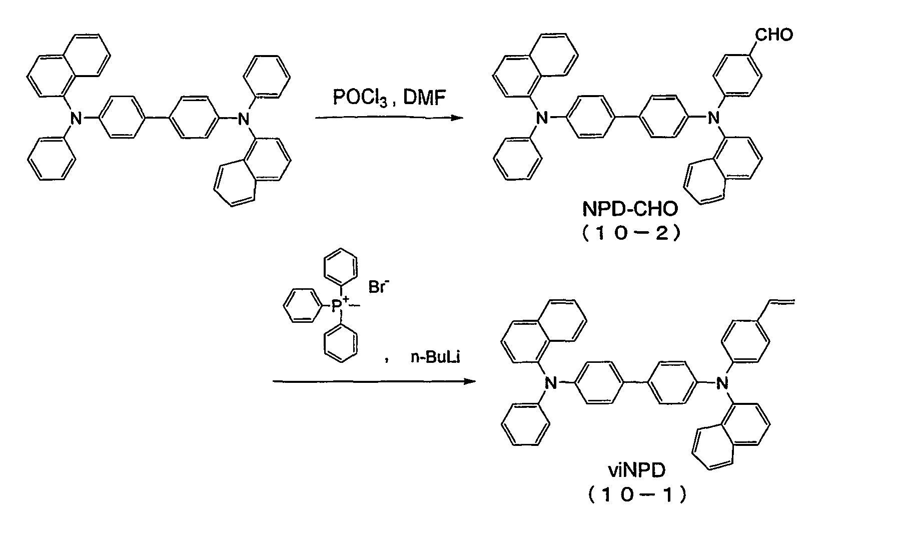

### (1) Formylation of 4,4'-bis(N-naphthyl-N-phenyl-amino)biphenyl

Under an argon atmosphere, 2.24 ml of phosphorus oxychloride was added to 40 ml of dry N,N-dimethylformamide and stirred for 30 minutes, and then 11.77 g of 4,4'-bis(N-naphthyl-N-phenyl-amino) biphenyl was added thereto and stirred at 80°C for 2 hours. After the reaction, the reaction liquid was added dropwise to 500 ml of a 1.0 M aqueous sodium carbonate solution, and the generated precipitates were separated by filtration. The precipitates were dissolved in 100 ml of dichloromethane, and 100 ml of pure water was added to the resultant. The organic layer was dried over magnesium sulfate, concentrated under a reduced pressure, and purified by a silica gel column chromatography using a developing solvent of a dichloromethane-hexane mixed solvent. The solvent was distilled off to obtain 3.21 g of a yellow solid of NPD-CHO (10-2) with a yield of 26%. The product was identified by ¹H-NMR. ¹H-NMR (270 MHz, CDCl₃, ppm): 9.90 (s, 1H, -CHO), 7.8-6.8 (m, 31H, ArH).

### (2) Vinylation of NPD-CHO

Under an argon atmosphere, 20 ml of dry benzene and 10 ml of dry THF were added to 2.68 g of methyltriphenylphosphonium bromide and cooled to 0°C. Thereto was added 4. 69 ml of a 1. 6 M butyl lithium hexane solution dropwise using a syringe, and stirred for 10 minutes to obtain a phosphorane solution. Under an argon atmosphere, to 3.08 g of NPD-CHO (10-2) was added 20 ml of dry benzene, and then thereto was added the above phosphorane solution using a syringe. The reaction liquid was stirred at the room temperature for 2 hours, thereto were added 20 ml of pure water and dichloromethane, and the water layer was subjected to extraction with dichloromethane 2 times. The organic layer was dried over magnesium sulfate, concentrated under a reduced pressure, and purified by a silica gel column chromatography using a developing solvent of a dichloromethane-hexane mixed solvent. The resultant was freeze-dried from a benzene solution to obtain 2.43 g of viNPD (10-1) with a yield of 79%. The product was identified by ¹H-NMR.
¹H-NMR (270 MHz, CDCl₃, ppm): 7.8-6.8 (m, 31H, ArH), 6.68 (dd, 1H, J= 17.4, 10. 9 Hz, -CH=CH₂) , 5.63 (d, 1H, J=17.6Hz, -CH=CH₂ (cis)), 5.15 (d, 1H, J = 11.1 Hz, -CH=CH₂ (trans)).

### Example 11: Synthesis of polymerizable compound viPTPD (11-1)

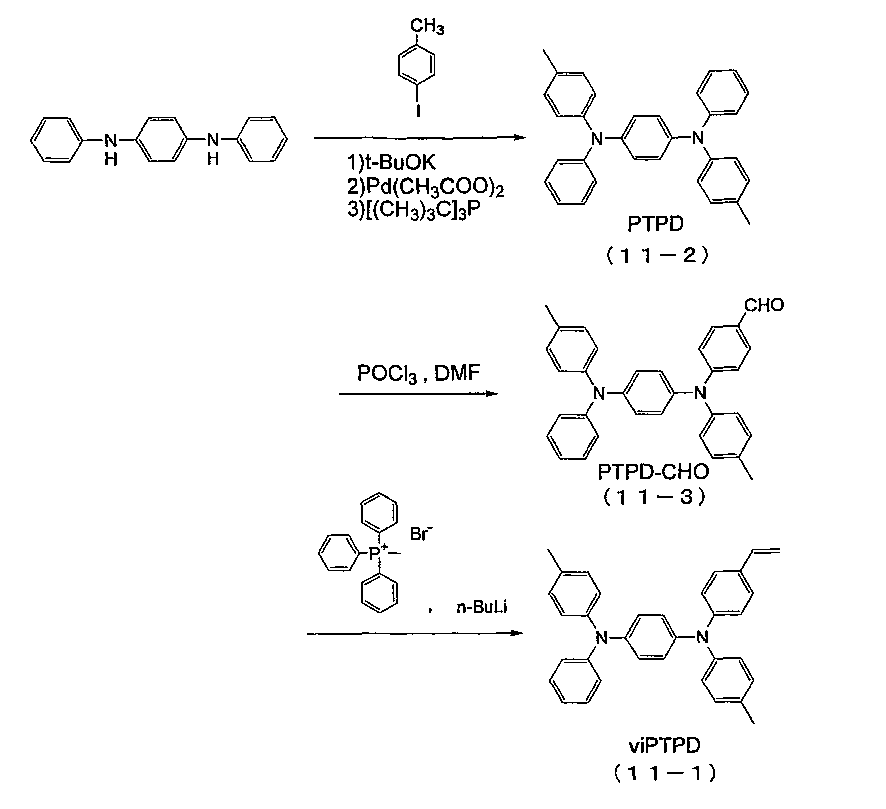

### (1) Ditolylation of N,N'-diphenyl-1,4-phenylenediamine

Under an argon atmosphere, 100 ml of dry toluene was added to 5.21 g of N,N'-diphenyl-1,4-phenylenediamine and 9.59 g of 4-iodotoluene, and heated to about 50°C. Thereto were added 5.39 g of potassium tert-butoxide, 90 mg of palladium acetate, and 243 mg of tri-tert-butylphosphine in this order, and the resulting mixture was refluxed for 4 hours while stirring. The reaction liquid was cooled to the room temperature, thereto was added 50 ml of pure water, and then the liquid was extracted with ethyl acetate 2 times. The organic layer was dried over magnesium sulfate, concentrated under a reduced pressure, and purified by a silica gel column chromatography using a developing solvent of a toluene-hexane mixed solvent. After the solvent was distilled off, the residue was recrystallized from hexane to obtain 6.43 g of PTPD (11-2) with a yield of 73%. The product was identified by ¹H-NMR.
¹H-NMR (270 MHz, CDCl₃, ppm) : 7.5-6.8 (m, 22H, ArH), 2.25 (s, 6H, -CH₃).

### (2) Formylation of PTPD

Under an argon atmosphere, 1.12 ml of phosphorus oxychloride was added to 20 ml of dry N,N-dimethylformamide and stirred for 30 minutes, and then 4.41 g of PTPD was added thereto and stirred at 80°C for 2 hours. After the reaction, the reaction liquid was added dropwise to 250 ml of a 1.0 M aqueous sodium carbonate solution, and the generated precipitates were separated by filtration. The precipitates were dissolved in 50 ml of dichloromethane, and 50 ml of pure water was added to the resultant. The organic layer was dried over magnesium sulfate, concentrated under a reduced pressure, and purified by a silica gel column chromatography using a developing solvent of a dichloromethane-hexane mixed solvent. The solvent was distilled off to obtain 2.06 g of a yellow solid of PTPD-CHO (11-3) with a yield of 44%. The product was identified by ¹H-NMR.
¹H-NMR (270 MHz, CDCl₃, ppm): 9.99 (s, 1H, -CHO), 7.7-6.8 (m, 21H, ArH), 2.28 (s, 6H, -CH₃).

### (3) Vinylation of PTPD-CHO

Under an argon atmosphere, 20 ml of dry benzene and 10 ml of dry THF were added to 2.14 g of methyltriphenylphosphonium bromide and cooled to 0°C. Thereto was added 3.75 ml of a 1.6 M butyl lithium hexane solution dropwise using a syringe, and stirred for 10 minutes to obtain a phosphorane solution. Under an argon atmosphere, to 1.87 g of PTPD-CHO (11-3) was added 20 ml of dry benzene, and then thereto was added the above phosphorane solution using a syringe. The reaction liquid was stirred at the room temperature for 2 hours, thereto were added 20 ml of pure water and dichloromethane, and the water layer was subjected to extraction with dichloromethane 2 times. The organic layer was dried over magnesium sulfate, concentrated under a reduced pressure, and purified by a silica gel column chromatography using a developing solvent of a dichloromethane-hexane mixed solvent. The resultant was freeze-dried from a benzene solution to obtain 1.46 g of viPTPD (11-1) with a yield of 78%. The product was identified by ¹H-NMR.
¹H-NMR (270 MHz, CDCl₃, ppm) : 7.5-6.9 (m, 21H, ArH), 6.66 (dd, 1H, J=17.6, 11.1 Hz, -CH=CH₂), 5. 62 (d, 1H, J=17.3Hz, -CH=CH₂ (cis)), 5.14 (d, 1H, J = 10.8 Hz, -CH=CH₂ (trans)).

### Comparative Example 1: Synthesis of copolymer poly-(VCz-co-viPBD-co-IrST)

460 mg of N-vinylcarbazole (VCz), 460 mg of viPBD (5-1), and 80 mg of IrST (3-1) were placed in an airtight vessel, and thereto was added 5.60 ml of dry toluene. To this was added 3.70 ml of a 0.1 M toluene solution of V-601 (low VOC type radical initiator, manufactured by Wako Pure Chemical Industries, Lid.), and the resulting liquid was subjected to freeze deaeration 5 times. The vessel was closed under vacuum, and the liquid was stirred at 60°C for 72 hours. After the reaction, the reaction liquid was added to 500 ml of methanol dropwise to generate precipitates. The precipitates were purified by repeating reprecipitation in a toluene-acetone solvent 2 times, and vacuum-dried at 50°C overnight, to obtain 953 mg of a pale yellow solid of poly- (VCz-co-viPBD-co-IrST) . By GPC measurement, it was estimated that the obtained copolymer had a number average molecular weight (Mn) of 4,700, a weight average molecular weight (Mw) of 12,500, and a molecular weight distribution index (Mw/Mn) of 2.64, in terms of polystyrene. The iridium content of the copolymer, measured by the ICP elemental analysis, was 1.9 mass%. Thus, it was estimated that the copolymer had a copolymerization mass ratio VCz/viPBD/IrST of 45.7/47.2/7.1.

### Example 12: Production of organic light emitting device and evaluation of EL properties

An organic light emitting device was produced using an ITO (indium tin oxide) -coated substrate (Nippo Electric Co., Ltd.) which was a 25-mm-square glass substrate with two 4-mm-width ITO electrodes formed in stripes as an anode on one surface of the substrate. First a poly (3,4-ethylenedioxythiophene)-polystyrene sulfonate (BAYTRON P (trade name) manufactured by Bayer Co. ) was applied onto the ITO anode of the ITO-having substrate by a spin coating method under conditions of a rotation rate 3,500 rpm and a coating time 40 seconds, and dried under a reduced pressure at 60°C for 2 hours in a vacuum drying apparatus, to form an anode buffer layer. The obtained anode buffer layer had a thickness of approximately 50 nm.

Then, a coating solution for forming a layer comprising a light emitting material and an electron transporting material was prepared. Thus, 45 mg of poly-(viTPD-co-IrST) synthesized in Example 3 and 45 mg of poly-vinylPBD synthesized by a method described in JP-A-10-1665 were dissolved in 2,910 mg of toluene (special grade, manufactured by Wako Pure Chemical Industries, Ltd.), and the obtained solution was passed through a filter with a pore size of 0.2 µm to obtain the coating solution. Next, the prepared coating solution was applied to the anode buffer layer by a spin coating method under conditions of a rotation rate 3, 000 rpm and a coating time 30 seconds, and dried at the room temperature (25°C) for 30 minutes, to form a light emitting layer. The obtained light emitting layer had a thickness of approximately 100 nm. Then the substrate with the light emitting layer was placed in a deposition apparatus, cesium was deposited thereon into a thickness of 2 nm at a deposition rate of 0.01 nm/s (by using an alkali metal dispenser manufactured by Saes Getters SpA as a cesium source), and aluminum was deposited as a cathode into a thickness of 250 nm at a deposition rate of 1 nm/s, to produce device 1. Here the cesium layer and the aluminum layer were each formed into two 3-mm-width stripes perpendicular to the longitudinal direction of the anode, and four 4-mm-long and 3-mm-wide organic light emitting devices were produced per one glass substrate.

The above organic EL device was driven by applying voltage using a programmable direct voltage/current source TR6143 manufactured by Advantest Corporation, and the luminance of the device was measured by a luminance meter BM-8 manufactured by Topcon Corporation. The emission starting voltage, the maximum luminance, and the external quantum efficiency corresponding to the luminance of 100 cd/m² thus obtained are shown in Table 2 respectively. (Each of the values is an average value of the four devices formed on one substrate.)

Devices 2 to 7 were produced in the same manner as the device 1 except for using the light emitting materials synthesized in Examples 4 to 8 and Comparative Example 1 and the other material as shown in Table 1. These devices were evaluated with respect to the EL properties in the same manner as the device 1. The results are shown in Table 2.

**Table 1**

| Device No. | Light emitting material | | Other material | |
|---|---|---|---|---|
| 1 (Example 3) | poly-(viTPD-co-IrST) | 45 mg | poly-viPBD | 45 mg |
| 2 (Examples 4) | poly-(viPMTPD-co-IrST) | 45 mg | poly-viPBD | 45 mg |
| 3 (Example 5) | poly-(viTPD-co-viPBD-co-IrST) | 90 mg | None | |
| 4 (Example 6) | poly-(viPMTPD-co-viPBD-co-IrST) | 90 mg | None | |
| 5 (Example 7) | poly-(vTPD-co-viOXD7-co-IrST) | 90 mg | None | |
| 6 (Example 8) | poly-(viTPD-co-viPBD-co-IrST(R)) | 90 mg | None | |
| 7(Comparative Example 1) | poly-(VCz-co-viPBD-co-IrST) | 90 mg | None | |

**Table 2**

| Device No. | Emission starting voltage [V] | Maximum luminance [cd/m²] | External quantum efficiency [%] |
|---|---|---|---|
| 1 (Example 3) | 2.5 | 32,500 | 8.7 |
| 2 (Example 4) | 2.5 | 36,800 | 9.8 |
| 3 (Example 5) | 2.6 | 29,100 | 7.6 |
| 4 (Example 6) | 2.6 | 33,400 | 8.3 |
| 5 (Example 7) | 3.3 | 8,900 | 3.2 |
| 6 (Example 8) | 3.5 | 13,100 | 3.0 |
| 7(Comparative Example 1) | 3.6 | 7,800 | 2.7 |

It is clear from Tables 1 and 2 that the light emitting devices of the present invention using the phosphorescent polymers having the hole transporting moieties with the triphenylamine structures showed low emission starting voltages, high maximum luminances, and high external quantum efficiencies as compared with the comparative light emitting device using the phosphorescent polymer having the vinylcarbazole hole transporting moiety.

### INDUSTRIAL APPLICABILITY

By using the phosphorescent polymer compound according to the present invention, there are provided the phosphorescent polymer material and the organic light emitting device using the same, which are capable of showing a high light emitting efficiency at a low voltage and suitable for increasing the emission area and for mass production.

## Claims

1. A phosphorescent polymer compound comprising a phosphorescent monomer unit and a monomer unit represented by the formula (1) : 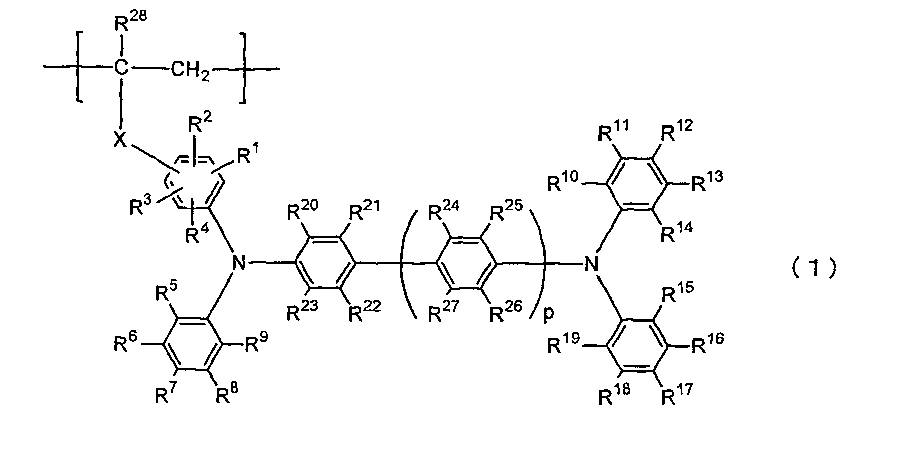 wherein R¹ to R²⁷ independently represent a hydrogen atom, a halogen atom, a cyano group, an amino group, an alkyl group having 1 to 6 carbon atoms, or an alkoxy group having 1 to 6 carbon atoms, groups of R¹ to R¹⁹ connecting to adjacent carbon atoms in the same phenyl group may be bonded together to form a condensed ring; R²⁸ represents a hydrogen atom or an alkyl group having 1 to 6 carbon atoms; X represents a single bond, an oxygen atom (-O-), a sulfur atom (-S-), -SO-, -SO₂-, -NR- (in which R represents a hydrogen atom, an alkyl group having 1 to 4 carbon atoms, or a phenyl group), -CO-, or a divalent organic group having 1 to 20 carbon atoms, the organic group may be substituted by atom or group selected from the group consisting of an oxygen atom (-O-), a sulfur atom (-S-), -SO-, -SO₂-, -NR- (in which R represents a hydrogen atom, an alkyl group having 1 to 4 carbon atoms, or a phenyl group), and -CO-; and p is 0 or 1.

2. The phosphorescent polymer compound according to claim 1, comprising the phosphorescent monomer unit and a monomer unit represented by the formula (2): 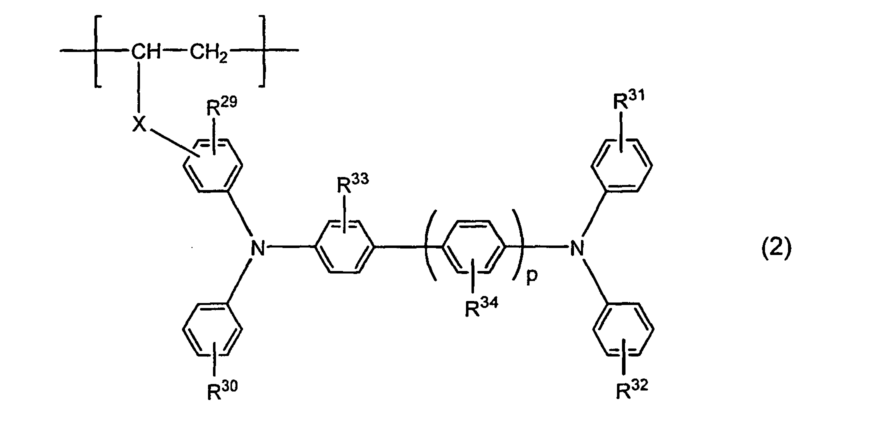 wherein R²⁹ to R³⁴ independently represent a hydrogen atom, an alkyl group having 1 to 6 carbon atoms, or an alkoxy group having 1 to 6 carbon atoms; X represents a single bond, an oxygen atom (-O-) , a sulfur atom (-S-), -SO-, -SO₂-, -NR- (in which R represents a hydrogen atom, an alkyl group having 1 to 4 carbon atoms, or a phenyl group), -CO-, or a divalent organic group having 1 to 20 carbon atoms, the organic group may be substituted by atom or group selected from the group consisting of an oxygen atom (-O-), a sulfur atom (-S-), -SO-, -SO₂-, -NR- (in which R represents a hydrogen atom, an alkyl group having 1 to 4 carbon atoms, or a phenyl group), and -CO-; and p is 0 or 1.

3. The phosphorescent polymer compound according to claim 1 or 2, further comprising an electron transporting monomer unit.

4. The phosphorescent polymer compound according to claim 3, wherein the electron transporting moiety in the electron transporting monomer unit is selected from the group consisting of an oxadiazole derivative, a triazole derivative, a triazine derivative, a benzoxazole derivative, an imidazole derivative and a quinolinol derivative metal complex.

5. The phosphorescent polymer compound according to claim 1 or 2, wherein the phosphorescent monomer unit comprises a polymerizable group and a phosphorescent moiety, and the phosphorescent moiety is contained in a side chain of the phosphorescent polymer.

6. The phosphorescent polymer compound according to claim 1 or 2, wherein the phosphorescent monomer unit comprises a transition metal complex.

7. An organic light emitting device comprising one or more polymer layers interposed between an anode and a cathode, wherein at least one of the polymer layers comprises the phosphorescent polymer compound according to any one of claims 1 to 6.

8. The organic light emitting device according to claim 7, comprising an anode subjected to UV ozone irradiation treatment or high-frequency plasma treatment.

9. The organic light emitting device according to claim 8, wherein the high-frequency plasma treatment is performed by using a gas containing an organic substance.

10. The organic light emitting device according to claim 9, wherein the gas containing an organic substance contains at least one of fluorocarbon and methane.

11. The organic light emitting device according to claim 8, wherein the high-frequency plasma treatment is performed by using a gas containing at least one of oxygen and argon.

## Patentansprüche

1. Phosphoreszierende Polymerverbindung, die eine phosphoreszierende Monomereinheit und eine Monomereinheit der Formel (1) umfasst: 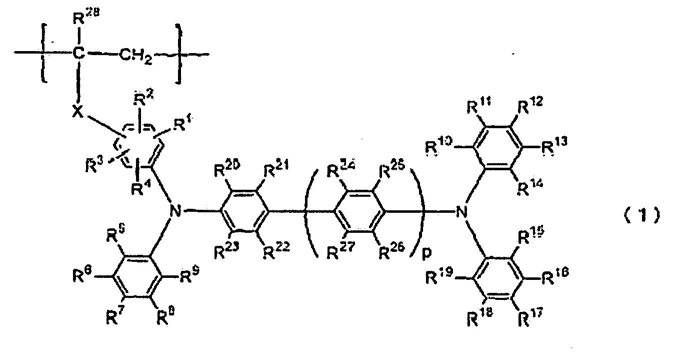 worin R¹ bis R²⁷ unabhängig voneinander ein Wasserstoffatom, ein Halogenatom, eine Cyangruppe, eine Aminogruppe, eine Alkylgruppe mit 1 bis 6 Kohlenstoffatomen oder eine Alkoxygruppe mit 1 bis 6 Kohlenstoffatomen darstellen, die Gruppen R¹ bis R¹⁹, die in derselben Phenylgruppe an benachbarte Kohlenstoffatome gebunden sind, können unter Bildung eines kondensierten Rings aneinander gebunden sein; R²⁸ stellt ein Wasserstoffatom oder eine Alkylgruppe mit 1 bis 6 Kohlenstoffatomen dar; X stellt eine Einfachbindung, ein Sauerstoffatom (-0-), ein Schwefelatom(-S-), -SO-,-SO₂-,-NR- (worin R ein Wasserstoffatom, eine Alkylgruppe mit 1 bis 4 Kohlenstoffatomen oder eine Phenylgruppe darstellt), -CO- oder eine zweiwertige organische Gruppe mit 1 bis 20 Kohlenstoffatomen dar, wobei die organische Gruppe mit einem Atom oder einer Gruppe substituiert sein kann, die aus der Gruppe ausgewählt ist, die aus einem Sauerstoffatom (-0-), eine Schwefelatom (-S-),-SO-,-S0₂-,-NR- (worin R ein Wasserstoffatom, eine Alkylgruppe mit 1 bis 4 Kohlenstoffatomen oder eine Phenylgruppe darstellt) und -CO- besteht; und p 0 oder 1 ist.

2. Phosphoreszierende Polymerverbindung nach Anspruch 1, welche die phosphoreszierende Monomereinheit und eine Monomereinheit der Formel (2) umfasst: 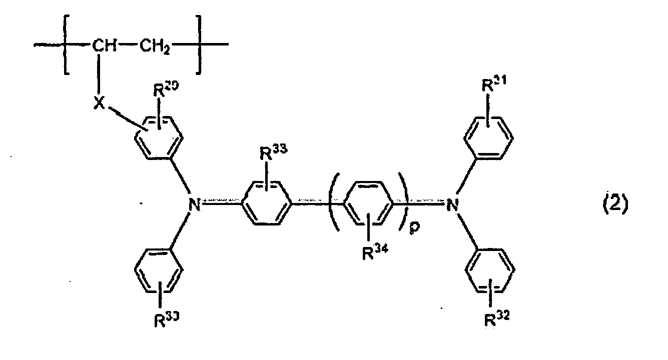 worin R²⁹ bis R³⁴ unabhängig voneinander ein Wasserstoffatom, eine Alkylgruppe mit 1 bis 6 Kohlenstoffatomen oder eine Alkoxygruppe mit 1 bis 6 Kohlenstoffatomen darstellen; X eine Einfachbindung, ein Sauerstoffatom (-0-), ein Schwefelatom (-S-),-SO-,-S0₂-,-NR- (worin R ein Wasserstoffatom, eine Alkylgruppe mit 1 bis 4 Kohlenstoffatomen oder eine Phenylgruppe darstellt), -CO- oder eine zweiwertige organische Gruppe mit 1 bis 20 Kohlenstoffatomen darstellt, wobei die organische Gruppe mit einem Atom oder einer Gruppe substituiert sein kann, die aus der Gruppe ausgewählt ist, die aus einem Sauerstoffatom (-0-), einem Schwefelatom (-S-),-SO-,-SO₂-, -NR- (worin R ein Wasserstoffatom, eine Alkylgruppe mit 1 bis 4 Kohlenstoffatomen oder eine Phenylgruppe darstellt) und - CO- besteht; und p 0 oder 1 ist.

3. Phosphoreszierende Polymerverbindung nach Anspruch 1 oder 2, die außerdem eine Elektronen transportierende Monomereinheit umfasst.

4. Phosphoreszierende Polymerverbindung nach Anspruch 3, worin der Elektronen transportierende Rest in der Elektronen - transportierenden Monomereinheit aus der Gruppe ausgewählt ist, die aus einem Oxadiazolderivat, einem Triazolderivat, einem Triazinderivat, einem Benzoxazolderivat, einem Imidazolderivat und einem Chinolinolderivatmetallkomplex besteht.

5. Phosphoreszierende Polymerverbindung nach Anspruch 1 oder 2, wobei die phosphoreszierende Monomereinheit eine polymerisierbare Gruppe und einen phosphoreszierenden Rest enthält und der phosphoreszierende Rest in einer Seitenkette des phosphoreszierenden Polymers enthalten ist.

6. Phosphoreszierende Polymerverbindung nach Anspruch 1 oder 2, worin die phosphoreszierende Monomereinheit einen Übergangsmetallkomplex enthält.

7. Vorrichtung zum Emittieren organischen Lichts, welche eine oder mehrere Polymerschichten enthält, die zwischen einer Anode und einer Kathode angebracht sind, wobei mindestens eine der Polymerschichten die phosphoreszierende Polymerverbindung nach einem der Ansprüche 1 bis 6 umfasst.

8. Vorrichtung zum Emittieren organischen Lichts nach Anspruch 7, welche eine Anode umfasst, die einer UV-Ozon-Bestrahlungsbehandlung oder Hochfrequenzplasmabehandlung unterworfen worden ist.

9. Vorrichtung zum Emittieren organischen Lichts nach Anspruch 8, wobei die Hochfrequenzplasmabehandlung unter Einsatz eines eine organische Substanz enthaltenden Gases durchgeführt wird.

10. Vorrichtung zum Emittieren organischen Lichts nach Anspruch 9, wobei das eine organische Substanz enthaltende Gas mindestens eine der Verbindungen Fluorkohlenstoff und Methan aufweist.

11. Vorrichtung zum Emittieren organischen Lichts nach Anspruch 8, wobei die Hochfrequenzplasmabehandlung unter Einsatz eines Gases, das mindestens eines der Gase Sauerstoff und Argon enthält, durchgeführt wird.

## Revendications

1. Composé polymère phosphorescent comprenant une unité monomère phosphorescente et une unité monomère représentée par la formule (1) : 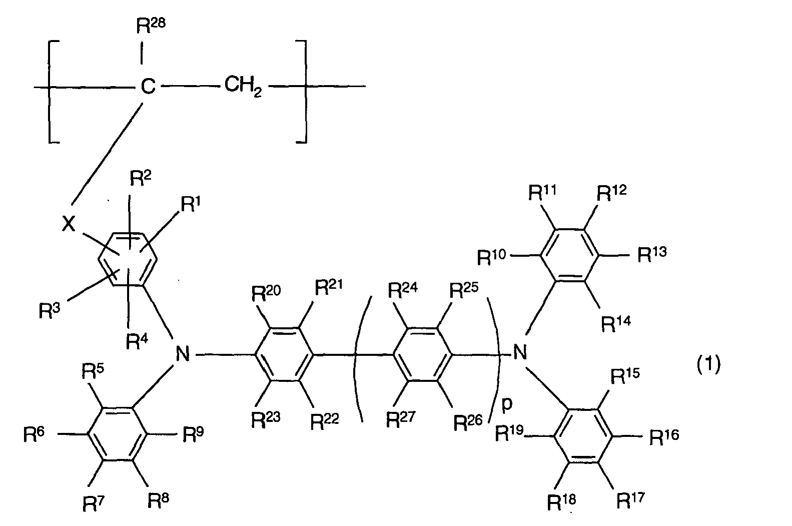 où R¹ à R²⁷ représentent indépendamment un atome d'hydrogène, un atome d'halogène, un groupe cyano, un groupe amino, un groupe alkyle ayant 1 à 6 atomes de carbone ou un groupe alcoxy ayant 1 à 6 atomes de carbone, les groupes de R¹ à R¹⁹ liés à des atomes de carbone adjacents dans le même groupe phényle peuvent être liés entre eux pour former un cycle condensé ; R²⁸ représente un atome d'hydrogène ou un groupe alkyle ayant 1 à 6 atomes de carbone ; X représente une simple liaison, un atome d'oxygène (-0-), un atome de soufre (-S-), -SO-, -SO₂-, -NR- (où R représente un atome d'hydrogène, un groupe alkyle ayant 1 à 4 atomes de carbone ou un groupe phényle), -CO-, ou un groupe organique divalent ayant 1 à 20 atomes de carbone, le groupe organique peut être substitué par un atome ou groupe choisi dans le groupe consistant en un atome d'oxygène (-0-), un atome de soufre (-S-), -SO-, - SO₂-, -NR- (où R représente un atome d'hydrogène, un groupe alkyle ayant 1 à 4 atomes de carbone ou un groupe phényle), et -CO- ; et p est 0 ou 1.

2. Composé polymère phosphorescent selon la revendication 1, comprenant l'unité monomère phosphorescente et une unité monomère représentée par la formule (2) : 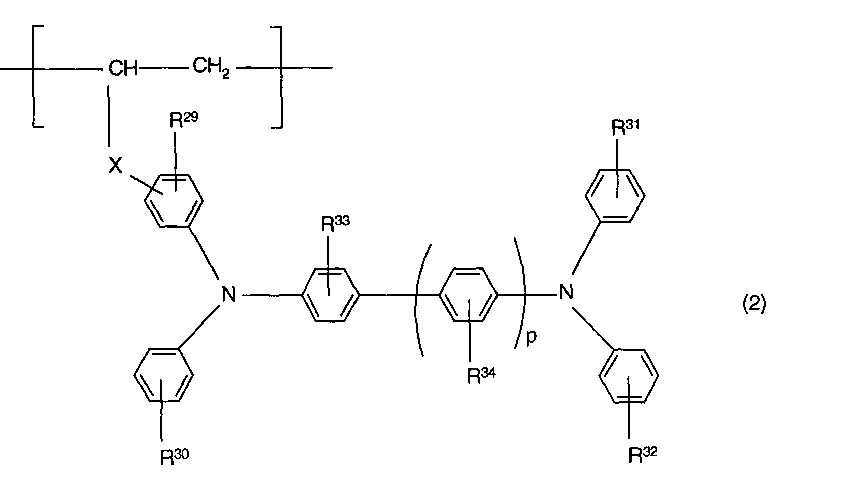 où R²⁹ à R³⁴ représentent indépendamment un atome d'hydrogène, un groupe alkyle ayant 1 à 6 atomes de carbone ou un groupe alcoxy ayant 1 à 6 atomes de carbone ; X représente une simple liaison, un atome d'oxygène (-O-), un atome de soufre (-S-), -SO-, -SO₂-, -NR- (où R représente un atome d'hydrogène, un groupe alkyle ayant 1 à 4 atomes de carbone ou un groupe phényle), -CO-, ou un groupe organique divalent ayant 1 à 20 atomes de carbone, le groupe organique peut être substitué par un atome ou groupe choisi dans le groupe consistant en un atome d'oxygène (-O-), un atome de soufre (-S-), -SO-, -SO₂-, -NR- (où R représente un atome d'hydrogène, un groupe alkyle ayant 1 à 4 atomes de carbone ou un groupe phényle), et -CO- ; et p est 0 ou 1.

3. Composé polymère phosphorescent selon la revendication 1 ou 2, comprenant en outre une unité monomère transportant des électrons.

4. Composé polymère phosphorescent selon la revendication 3, où le groupement transportant des électrons dans l'unité monomère transportant des électrons est choisi dans le groupe consistant en un dérivé d'oxadiazole, un dérivé de triazole, un dérivé de triazine, un dérivé de benzoxazole, un dérivé d'imidazole et un complexe métallique de dérivé de quinolinol.

5. Composé polymère phosphorescent selon la revendication 1 ou 2, où l'unité monomère phosphorescente comprend un groupe polymérisable et un groupement phophorescent, et le groupement phosphorescent est contenu dans une chaîne latérale du polymère phosphorescent.

6. Composé polymère phosphorescent selon la revendication 1 ou 2, où l'unité monomère phosphorescente comprend un complexe de métal de transition.

7. Dispositif luminescent organique comprenant une ou plusieurs couches polymères disposées entre une anode et une cathode, où au moins l'une des couches polymères comprend le composé polymère phosphorescent selon l'une quelconque des revendications 1 à 6.

8. Dispositif luminescent organique selon la revendication 7, comprenant une anode soumise à un traitement d'irradiation à l'ozone et aux U.V. ou un traitement à plasma haute fréquence.

9. Dispositif luminescent organique selon la revendication 8, où le traitement à plasma haute fréquence est mis en oeuvre au moyen d'un gaz contenant une substance organique.

10. Dispositif luminescent organique selon la revendication 9, où le gaz contenant une substance organique contient au moins l'un parmi un fluorocarbure et le méthane.

11. Dispositif luminescent organique selon la revendication 8, où le traitement à plasma haute fréquence est mis en oeuvre au moyen d'un gaz contenant au moins l'un parmi l'oxygène et l'argon.
